# EUROPEAN PATENT SPECIFICATION

(11) **EP 4 593 555 B1**
(45) Date of publication and mention of the grant of the patent: **11.03.2026**
(21) Application number: 24196347.9
(22) Date of filing: 26.08.2024
(51) Int. Cl.: H10F 10/14, H10F 71/00, H10F 77/20

(54) **BACK CONTACT SOLAR CELL AND METHOD FOR MANUFACTURING THE SAME**
RÜCKKONTAKTSOLARZELLE UND VERFAHREN ZU IHRER HERSTELLUNG
CELLULE SOLAIRE À CONTACT ARRIÈRE ET SON PROCÉDÉ DE FABRICATION

(30) Priority: 26.01.2024 CN 202410111957
(43) Date of publication of application: 30.07.2025
(60) Divisional application: 26156028.8
(73) Proprietor: Longi Green Energy Technology Co., Ltd., Xi'an, Shaanxi 710100 (CN)
(72) Inventor: LI, Zhenguo, SHAANXI, 710100 (CN); TONG, Hongbo, SHAANXI, 710100 (CN); LIU, Qingping, SHAANXI, 710100 (CN); DONG, Guangbin, SHAANXI, 710100 (CN); DING, Chao, SHAANXI, 710100 (CN); ZHANG, Hongchao, SHAANXI, 710100 (CN); CHEN, Chen, China, 710100 (CN); XU, Xinxing, SHAANXI, 710100 (CN); WANG, Yanzeng, SHAANXI, 710100 (CN)
(74) Representative: Pfenning, Meinig & Partner mbB

(56) References cited:
- EP-A1- 4 123 723
- EP-A1- 4 195 299
- CN-U- 205 542 815
- US-A1- 2023 027 636

## Description

### TECHNICAL FIELD

The present invention relates to the field of photovoltaic technologies, and in particular, to a back contact solar cell and a method for manufacturing the same.

### BACKGROUND

Aback contact solar cell is a solar cell in which no electrode is arranged on a light receiving surface of the solar cell and positive and negative electrodes are all arranged on a back surface of the solar cell, so that blocking of the solar cell by the electrodes can be reduced, a short-circuit current of the solar cell can be increased, and the energy conversion efficiency of the solar cell can be improved. In addition, a surface passivation layer may be formed on the back surface of the back contact solar cell to reduce a carrier recombination rate on the back surface of the back contact solar cell, thereby improving the photoelectric conversion efficiency of the back contact solar cell.

However, existing back contact solar cells have low carrier collection efficiency, which is not conducive to improving the operating performance of the back contact solar cell.

CN 205 542 815 U discloses a an IBC solar cell, comprising an N-type silicon wafer, the N-type silicon wafer having a velvet surface and a polished surface, the velvet surface side of the N-type silicon wafer comprising an n+ surface field layer, the n+ surface field layer being formed on the velvet surface, wherein the polished surface side of the N-type silicon wafer includes a p+ emitter region, an n++ surface field region, and an isolation region, wherein the p+ emitter region is formed on the polished surface, the isolation region is adjacent to the p+ emitter region and the n++ surface field region, respectively, and the isolation region extends into the N-type silicon wafer, the top surface of the n++ surface field region is flush with the polished surface of the N-type silicon wafer, and the n++ surface field region extends into the N-type silicon wafer, wherein the IBC solar cell further comprises a first passivation anti-reflection film layer and a second passivation anti-reflection film layer, wherein the first passivation anti-reflection film layer is located on the n+ surface field layer, and the second passivation anti-reflection film layer covers the p+ emitter region, the n++ surface field region, and the isolation region, and wherein the IBC solar cell further comprises a positive electrode and a negative electrode, both of which are located on the second passivation anti-reflection film layer, and the positive electrode extends toward the p+ emitter region and extends to the top surface of the p+ emitter region, and the negative electrode extends toward the n++ surface field region and extends to the top surface of the n++ surface field region.

### SUMMARY

An objective of the present invention is to provide a back contact solar cell and a method for manufacturing the same, to shorten movement distances of some carriers and improve the carrier collection efficiency while preventing a first doped semiconductor layer and a second doped semiconductor layer from being electrically connected to each other, helping improve the operating performance of the back contact solar cell.

The invention is set out in the appended set of claims.

To achieve the foregoing objective, according to a first aspect, the present invention provides a back contact solar cell, including: a silicon substrate, and a first doped semiconductor layer and a second doped semiconductor layer alternately distributed at intervals on a back surface of the silicon substrate. A conductivity type of the first doped semiconductor layer is opposite to a conductivity type of the second doped semiconductor layer. In the back surface of the silicon substrate, regions corresponding to the first doped semiconductor layer are defined as first regions, regions corresponding to the second doped semiconductor layer are defined as second regions, and a region located between each first region and a second region adjacent to the first region is defined as an isolation region, where a plurality of isolation regions are provided. A side surface of each of the first doped semiconductor layer and the second doped semiconductor layer close to the isolation region is wave-shaped, wherein a fluctuation amplitude corresponding to the side surface of the second doped semiconductor layer close to the isolation region is greater than a fluctuation amplitude corresponding to the side surface of the first doped semiconductor layer close to the isolation region, and/or a fluctuation frequency corresponding to the side surface of the second doped semiconductor layer close to the isolation region is less than a fluctuation frequency corresponding to the side surface of the first doped semiconductor layer close to the isolation region. A surface of each of the second regions is recessed into the silicon substrate relative to a surface of each of the first regions. A surface of the isolation region is recessed into the silicon substrate relative to the surface of each of the second regions, and a depth by which the surface of the isolation region is recessed into the silicon substrate relative to the surface of each of the first regions is less than 3000 nm.

In a case that the foregoing technical solution is used, in the back contact solar cell provided in the present invention, the first doped semiconductor layer and the second doped semiconductor layer having opposite conductivity types are alternately distributed at intervals on the back surface of the silicon substrate. Based on this, the isolation region on the back surface of the silicon substrate can separate the first doped semiconductor layer from the second doped semiconductor layer, thereby reducing a carrier recombination rate at a lateral junction of the first doped semiconductor layer and the second doped semiconductor layer, which helps improve the photoelectric conversion efficiency of the back contact solar cell. Besides, the first doped semiconductor layer is formed on the first regions of the back surface, and the second doped semiconductor layer is formed on the second regions of the back surface. Therefore, when the surface of each of the second regions is recessed into the silicon substrate relative to the surface of each of the first regions, and the surface of the isolation region is recessed into the silicon substrate relative to the surface of each of the second regions, it indicates that after selective etching is performed on a first doped semiconductor layer entirely covering the back surface in an actual manufacturing procedure, not only parts of the first doped semiconductor layer located on the second regions and the isolation regions are completely removed, but also the silicon substrate of a partial thickness is further etched, to ensure that no first doped semiconductor layer remains on the second regions and the isolation regions, thereby preventing short circuit. In addition, the first doped semiconductor layer and the second doped semiconductor layer located on the back surface of the silicon substrate and having opposite conductivity types can be at least partially staggered from each other along a thickness direction of the silicon substrate, thereby further reducing a risk of current leakage on the back surface, and improving the electrical reliability of the back contact solar cell. Similarly, when the surface of the isolation region is recessed into the silicon substrate relative to the surface of each of the second regions, it indicates that after selective etching is performed on the second doped semiconductor layer deposited on the first doped semiconductor layer, the second regions, and the isolation regions in an actual manufacturing procedure, not only parts of the second doped semiconductor layer located on the first doped semiconductor layer and the isolation regions are completely removed, but also the silicon substrate of a partial thickness corresponding to the isolation region is further etched, to ensure that no second doped semiconductor layer remains on the first doped semiconductor layer and the isolation regions, thereby preventing short circuit.

In addition, it can be learned from the foregoing content that, in the back surface of the silicon substrate, a depth by which the isolation region is recessed into the silicon substrate is largest, and the depth by which the isolation region is recessed into the silicon substrate relative to the surface of each of the first regions is less than 3000 nm. Based on this, compared with the related art in which the isolation region is recessed into the silicon substrate by more than 5 µm, in the back contact solar cell provided in the present invention, the isolation region is recessed into the silicon substrate by a smaller depth. In this case, carriers of a corresponding conductivity type can be collected by the first doped semiconductor layer or the second doped semiconductor layer without bypassing an isolation region with a large depth, so that movement distances of some carriers can be shortened and the carrier collection efficiency can be improved, helping improve the operating performance of the back contact solar cell.

In a possible implementation, the surface of the isolation region is a planar surface. In this case, the surface of the isolation region is relatively flat. Based on this, when the back contact solar cell further includes a surface passivation layer, compared with a textured surface, a thickness of a part of the surface passivation layer formed on the isolation region whose surface is planar is greater, which can improve a passivation effect of the surface passivation layer on the isolation region, thereby reducing a carrier recombination rate on the surface of the isolation region and helping improve the photoelectric conversion efficiency of the back contact solar cell.

In a possible implementation, a roughness of the surface of the isolation region is less than or equal to 30 µm per 10000 square micrometers. Beneficial effects in this case are similar to the beneficial effects when the surface of the isolation region is a planar surface, and details are not described herein again.

In a possible implementation, a length of the isolation region along an arrangement direction of the first regions and the second regions is greater than or equal to 20 µm and less than or equal to 110 µm.

In a case that the foregoing technical solution is used, when the length of the isolation region falls within the foregoing range, current leakage between the first doped semiconductor layer and the second doped semiconductor layer caused by a small gap can be prevented, thereby ensuring high electrical reliability of the back contact solar cell. In addition, it can also be prevented that carriers on the back surface cannot be collected by the first doped semiconductor layer and/or the second doped semiconductor layer in time and led out by corresponding electrodes in a case that formation ranges of the first doped semiconductor layer and/or the second doped semiconductor layer on the back surface are small due to a large gap, thereby further reducing the carrier recombination rate on the back surface.

In a possible implementation, the surface of each of the second regions is a planar surface.

In this case, the surface of each of the second regions is relatively flat, which helps improve the formation quality of the second doped semiconductor layer formed on each of the second regions. In addition, a height fluctuation of a surface of the second doped semiconductor layer formed on each of the second regions is similar to a height fluctuation of the surface of each of the second regions. Therefore, when the surface of each of the second regions is a planar surface, it further helps improve the surface flatness of a side of the second doped semiconductor layer facing away from the silicon substrate. Based on this, when the back contact solar cell further includes a surface passivation layer, compared with a textured surface, a thickness of a part of the surface passivation layer formed on the second doped semiconductor layer whose surface has relatively high flatness is greater, which can improve a passivation effect of the surface passivation layer on the side of the second doped semiconductor layer facing away from the silicon substrate, thereby further reducing the carrier recombination rate on the back surface of the back contact solar cell and helping improve the photoelectric conversion efficiency of the back contact solar cell.

In a possible implementation, a depth by which the surface of each of the second regions is recessed into the silicon substrate is greater than or equal to 100 nm and less than or equal to 1000 nm.

In a case that the foregoing technical solution is used, when the depth by which the surface of each of the second regions is recessed into the silicon substrate falls within the foregoing range, it can be prevented that a degree at which the first doped semiconductor layer and the second doped semiconductor layer located on the back surface of the silicon substrate and having opposite conductivity types are staggered from each other is small along the thickness direction of the silicon substrate caused by a small depth by which the surface of each of the second regions is recessed into the silicon substrate, thereby further reducing the risk of current leakage on the back surface. In addition, the isolation region is recessed into the silicon substrate relative to each of the second regions, that is, compared with the second region, the depth by which the isolation region is recessed into the silicon substrate is larger. Therefore, when the depth by which the surface of each of the second regions is recessed into the silicon substrate falls within the foregoing range, it can be prevented that the depth by which the isolation region is recessed into the silicon substrate becomes larger caused by a large depth by which the surface of each of the second regions is recessed into the silicon substrate, thereby ensuring that movement distances of some carriers bypassing the isolation region and being transmitted to the first doped semiconductor layer or the second doped semiconductor layer are relatively small. In addition, it can also be prevented that a silicon substrate with a large thickness needs to be used due to large depths by which each of the second regions and the isolation region are recessed into the silicon substrate, so that production of a thin back contact solar cell can be implemented while manufacturing costs of the back contact solar cell can be reduced.

In a possible implementation, a height difference between the surface of each of the second regions and the surface of the isolation region is greater than or equal to 300 nm and less than 2000 nm.

In a case that the foregoing technical solution is used, when the height difference between the surface of each of the second regions and the surface of the isolation region falls within the foregoing range, it can be prevented that an etching depth of an etchant to the isolation region of the silicon substrate can be small only by strictly controlling an etching time after a part of the second doped semiconductor layer on the isolation region is completely removed in an actual manufacturing procedure due to a small height difference, thereby reducing the etching difficulty. It can also be prevented that a reduction degree of movement distances of carriers of a corresponding conductivity type is not apparent caused by a large height difference, thereby ensuring that the carrier collection efficiency can be improved.

According to the invention, a side surface of each of the first doped semiconductor layer and the second doped semiconductor layer close to the isolation region is wave-shaped, where a fluctuation amplitude corresponding to the side surface of the second doped semiconductor layer close to the isolation region is greater than a fluctuation amplitude corresponding to the side surface of the first doped semiconductor layer close to the isolation region, and/or a fluctuation frequency corresponding to the side surface of the second doped semiconductor layer close to the isolation region is less than a fluctuation frequency corresponding to the side surface of the first doped semiconductor layer close to the isolation region.

In the foregoing technical solution, when the side surface of each of the first doped semiconductor layer and the second doped semiconductor layer close to the isolation region is wave-shaped, if the fluctuation amplitude corresponding to the side surface of the second doped semiconductor layer close to the isolation region is greater than the fluctuation amplitude corresponding to the side surface of the first doped semiconductor layer close to the isolation region, a roughness of a local region of the side surface of the second doped semiconductor layer close to the isolation region is less than a roughness of a local region of the side surface of the first doped semiconductor layer close to the isolation region, thereby helping reduce a quantity of defects of a part of the second doped semiconductor layer formed close to the isolation region, reducing a carrier recombination rate at the part of the second doped semiconductor layer close to the isolation region, and further improving the operating performance of the back contact solar cell.

In a possible implementation, at least part of a surface in side walls of the isolation region is arranged obliquely relative to a horizontal plane, so that a cross-sectional area of at least part of the isolation region gradually increases along a direction from a light receiving surface of the silicon substrate to the back surface.

In a case that the foregoing technical solution is used, when a cross-sectional area of a side of the isolation region close to the light receiving surface is less than a cross-sectional area of a side of the isolation region close to the back surface, a gap between a first doped semiconductor layer and a second doped semiconductor layer having a conductivity type opposite to that of the first doped semiconductor layer can be increased, thereby reducing the risk of current leakage on the back surface of the back contact solar cell and ensuring high electrical reliability of the back contact solar cell. **In** addition, the part in the side walls of the isolation region arranged obliquely relative to the horizontal plane also helps reflect light, so that more light enters the silicon substrate from the back surface of the back contact solar cell under a reflection effect of the part in the side walls of the isolation region arranged obliquely relative to the horizontal plane, thereby improving the photoelectric conversion efficiency of the back contact solar cell.

In a possible implementation, the back contact solar cell further includes a surface passivation layer covering the first doped semiconductor layer, the second doped semiconductor layer, and the isolation regions.

In a case that the foregoing technical solution is used, the surface passivation layer may passivate the back surface of the back contact solar cell, thereby reducing the carrier recombination rate on the back surface. **In** addition, the recessed depth corresponding to the isolation region with the largest recessed depth into the silicon substrate is less than 3000 nm, so that a height fluctuation of each region on the back surface of the back contact solar cell is small, helping increase a formation thickness of the surface passivation layer on the back surface and improve a passivation effect of the surface passivation layer on the back surface.

**In** a possible implementation, the back contact solar cell further includes a first passivation layer between the first regions of the silicon substrate and the first doped semiconductor layer.

In a case that the foregoing technical solution is used, the first passivation layer and the first doped semiconductor layer may form a selective contact structure to perform chemical passivation on the first regions on the back surface of the silicon substrate and selectively collect carriers of a corresponding conductivity type, thereby reducing the carrier recombination rate on the back surface and helping improve the photoelectric conversion efficiency of the back contact solar cell.

In a possible implementation, the back contact solar cell further includes a second passivation layer between the second regions of the silicon substrate and the second doped semiconductor layer.

In a case that the foregoing technical solution is used, the second passivation layer and the second doped semiconductor layer may form a selective contact structure to perform chemical passivation on the second regions on the back surface of the silicon substrate and selectively collect carriers of a corresponding conductivity type, thereby reducing the carrier recombination rate on the back surface and helping improve the photoelectric conversion efficiency of the back contact solar cell.

In a possible implementation, in a case that the back contact solar cell includes the first passivation layer and the first passivation layer is a tunneling passivation layer, the first doped semiconductor layer is a doped polysilicon layer.

In a possible implementation, in a case that the back contact solar cell includes the second passivation layer and the second passivation layer is a tunneling passivation layer, the second doped semiconductor layer is a doped polysilicon layer.

In addition, according to a second aspect, the prevent invention further provides a back contact solar cell, including: a silicon substrate, and a first doped semiconductor layer and a second doped semiconductor layer alternately distributed at intervals on a back surface of the silicon substrate.

A conductivity type of the first doped semiconductor layer is opposite to a conductivity type of the second doped semiconductor layer. In the back surface of the silicon substrate, regions corresponding to the first doped semiconductor layer are defined as first regions, regions corresponding to the second doped semiconductor layer are defined as second regions, and a region located between each first region and a second region adjacent to the first region is defined as an isolation region, where a plurality of isolation regions are provided. A side surface of each of the first doped semiconductor layer and the second doped semiconductor layer close to the isolation region is wave-shaped, wherein a fluctuation amplitude corresponding to the side surface of the second doped semiconductor layer close to the isolation region is greater than a fluctuation amplitude corresponding to the side surface of the first doped semiconductor layer close to the isolation region, and/or a fluctuation frequency corresponding to the side surface of the second doped semiconductor layer close to the isolation region is less than a fluctuation frequency corresponding to the side surface of the first doped semiconductor layer close to the isolation region.

According to the invention, a fluctuation amplitude corresponding to the side surface of the second doped semiconductor layer close to the isolation region is greater than a fluctuation amplitude corresponding to the side surface of the first doped semiconductor layer close to the isolation region, and/or a fluctuation frequency corresponding to the side surface of the second doped semiconductor layer close to the isolation region is less than a fluctuation frequency corresponding to the side surface of the first doped semiconductor layer close to the isolation region.

In a possible implementation, a surface of each of the second regions is recessed into the silicon substrate relative to a surface of each of the first regions; and a surface of the isolation region is recessed into the silicon substrate relative to the surface of each of the second regions.

In a possible implementation, at least part of a surface in side walls of the isolation region is arranged obliquely relative to a horizontal plane, so that a cross-sectional area of at least part of the isolation region gradually increases along a direction from a light receiving surface of the silicon substrate to the back surface.

According to a second aspect, the present invention provides a method for manufacturing a back contact solar cell. The method for manufacturing a back contact solar cell includes: providing a silicon substrate, where a back surface of the silicon substrate includes first regions and second regions alternately distributed at intervals and an isolation region located between each first region and a second region adjacent to the first region; forming a first doped semiconductor layer on the first regions, and causing a surface of the isolation region and a surface of each of the second regions to be recessed into the silicon substrate relative to a surface of each of the first regions; and forming a second doped semiconductor layer on the second regions, and causing the surface of the isolation region to be recessed into the silicon substrate relative to the surface of each of the second regions, and causing a depth by which the surface of the isolation region is recessed into the silicon substrate relative to the surface of each of the first regions to be less than 3000 nm, wherein a side surface of each of the first doped semiconductor layer and the second doped semiconductor layer close to the isolation region is wave-shaped, and wherein a fluctuation amplitude corresponding to the side surface of the second doped semiconductor layer close to the isolation region is greater than a fluctuation amplitude corresponding to the side surface of the first doped semiconductor layer close to the isolation region, and/or a fluctuation frequency corresponding to the side surface of the second doped semiconductor layer close to the isolation region is less than a fluctuation frequency corresponding to the side surface of the first doped semiconductor layer close to the isolation region.

In a possible implementation, after the providing a silicon substrate and before the forming a second doped semiconductor layer on the second regions, the method for manufacturing a back contact solar cell includes: forming a first doped semiconductor layer entirely arranged on the back surface of the silicon substrate and a first mask layer located on parts of the first doped semiconductor layer corresponding to the first regions; and selectively removing parts of the first doped semiconductor layer located on the isolation regions and the second regions using the first mask layer, and causing the surface of the isolation region and the surface of each of the second regions to be recessed into the silicon substrate relative to the surface of each of the first regions.

In a possible implementation, a material of the first doped semiconductor layer includes silicon; and the forming a first doped semiconductor layer entirely arranged on the back surface of the silicon substrate and a first mask layer located on parts of the first doped semiconductor layer corresponding to the first regions includes: forming a first intrinsic semiconductor layer entirely arranged on the back surface of the silicon substrate; performing doping treatment on the first intrinsic semiconductor layer, to form the first intrinsic semiconductor layer into the first doped semiconductor layer, and forming a first doped silicate glass layer entirely arranged on the first doped semiconductor layer; performing heat treatment on parts of the first doped silicate glass layer corresponding to the isolation regions and the second regions by using a laser etching process, to form parts of the first doped silicate glass layer on which the heat treatment is not performed into the first mask layer; and removing the parts of the first doped silicate glass layer on which the heat treatment is performed.

In a case that the foregoing technical solution is used, when the material of the first doped semiconductor layer includes silicon, a material of the first intrinsic semiconductor layer for manufacturing the first doped semiconductor layer also includes silicon. Based on this, after doping treatment is performed on the first intrinsic semiconductor layer, not only the first doped semiconductor layer can be obtained, but also the first doped silicate glass layer entirely arranged can be formed on the first doped semiconductor layer. Heat treatment is then performed on part of the first doped silicate glass layer by using the laser etching process. In this case, the part of the first doped silicate glass layer on which laser treatment is performed has poor density and is easy to remove. A part of the first doped silicate glass layer on which laser treatment is not performed has high density and is not easy to remove. Therefore, after the heat treatment, different parts of the first doped silicate glass layer have different etching selection ratios, and when the first mask layer for patterning the first doped semiconductor layer is obtained, there is no need to additionally form other mask materials and other mask deposition processes to obtain the first mask layer, thereby helping reduce the manufacturing costs of the back contact solar cell and simplifying a manufacturing procedure of the back contact solar cell.

In a possible implementation, the method further includes: selectively removing the parts of the first doped semiconductor layer located on the isolation regions and the second regions by using a wet chemical process using the first mask layer, and causing the surface of the isolation region and the surface of each of the second regions to be recessed into the silicon substrate relative to the surface of each of the first regions, where a process temperature of the wet chemical process is greater than or equal to 60°C and less than or equal to 80°C; and/or a process time of the wet chemical process is greater than or equal to 40s and less than or equal to 200s; and/or a wet chemical etching solution used in the wet chemical process is an alkaline wet chemical etching solution, and a volume proportion of an alkaline component in the alkaline wet chemical etching solution is greater than or equal to 2% and less than or equal to 20%; and/or the wet chemical etching solution used in the wet chemical process includes a polishing additive, and a volume proportion of the polishing additive in the wet chemical etching solution is greater than or equal to 0.5% and less than or equal to 5%.

In a case that the foregoing technical solution is used, both the process temperature and the process time of the wet chemical process affect depths by which the surface of the isolation region and the surface of each of the second regions are caused to be recessed into the silicon substrate relative to the surface of each of the first regions through the wet chemical process. Based on this, when the process temperature of the wet chemical process falls within the foregoing range, small depths by which the surface of the isolation region and the surface of each of the second regions are recessed into the silicon substrate relative to the surface of each of the first regions caused by a low process temperature can be prevented. In addition, large depths by which the surface of the isolation region and the surface of each of the second regions are recessed into the silicon substrate relative to the surface of each of the first regions caused by a high process temperature can also be prevented. After this operation, both the depths by which the surface of the isolation region and the surface of each of the second regions are recessed into the silicon substrate relative to the surface of each of the first regions are equal to a depth by which the surface of each of the second regions is recessed into the silicon substrate relative to the surface of each of the first regions in the formed back contact solar cell. For beneficial effects of preventing the depth by which the surface of each of the second regions is recessed into the silicon substrate relative to the surface of each of the first regions from being excessively large and excessively small, reference may be made to the foregoing content. Besides, beneficial effects of the process time and the volume proportion of the alkaline component falling with the foregoing ranges are similar to the beneficial effects that the process temperature is greater than or equal to 60°C and less than or equal to 80°C, and details are not described herein again. In addition, when the volume proportion of the polishing additive in the wet chemical etching solution falls within the foregoing range, the flatness of the surface of the isolation region and the surface of each of the second regions after this operation can be improved, thereby further improving a passivation effect of the surface passivation layer on the isolation region and the second doped semiconductor layer.

In a possible implementation, after the causing a surface of the isolation region and a surface of each of the second regions to be recessed into the silicon substrate relative to a surface of each of the first regions, the method for manufacturing a back contact solar cell includes: depositing a second doped semiconductor layer on the first doped semiconductor layer, the isolation regions, and the second regions, and forming a second mask layer on parts of the second doped semiconductor layer corresponding to the second regions; and selectively removing parts of the second doped semiconductor layer corresponding to the first regions and the isolation regions using the second mask layer, and causing the surface of the isolation region to be recessed into the silicon substrate relative to the surface of each of the second regions.

In a possible implementation, a material of the second doped semiconductor layer includes silicon; and the depositing a second doped semiconductor layer on the first doped semiconductor layer, the isolation regions, and the second regions, and forming a second mask layer on parts of the second doped semiconductor layer corresponding to the second regions includes: depositing a second intrinsic semiconductor layer on the first doped semiconductor layer, the isolation regions, and the second regions; performing doping treatment on the second intrinsic semiconductor layer, to form the second intrinsic semiconductor layer into the second doped semiconductor layer, and forming a second doped silicate glass layer entirely arranged on the second doped semiconductor layer; performing heat treatment on parts of the second doped silicate glass layer corresponding to the first regions and the isolation regions by using a laser etching process, to form parts of the second doped silicate glass layer corresponding to the second regions into the second mask layer; and removing the parts of the second doped silicate glass layer on which the heat treatment is performed.

In a case that the foregoing technical solution is used, when the material of the second doped semiconductor layer includes silicon, a material of the second intrinsic semiconductor layer for manufacturing the second doped semiconductor layer also includes silicon. Based on this, after doping treatment is performed on the second intrinsic semiconductor layer, not only the second doped semiconductor layer can be obtained, but also the second doped silicate glass layer entirely arranged can be formed on the second doped semiconductor layer. Heat treatment is then performed on the parts of the second doped silicate glass layer corresponding to the first regions and the isolation regions by using the laser etching process. In this case, the parts of the second doped silicate glass layer on which laser treatment is performed have poor density and are easy to remove. Laser treatment is not performed on the parts of the second doped silicate glass layer corresponding to the second regions. In this case, the parts of the second doped silicate glass layer corresponding to the second regions have high density and are not easy to remove. Therefore, after the heat treatment, different parts of the second doped silicate glass layer have different etching selection ratios, and when the second mask layer for patterning the second doped semiconductor layer is obtained, there is no need to additionally form other mask materials and other mask deposition processes to obtain the second mask layer, thereby helping reduce the manufacturing costs of the back contact solar cell and simplifying a manufacturing procedure of the back contact solar cell.

In a possible implementation, the method further includes: selectively removing the parts of the second doped semiconductor layer corresponding to the first regions and the isolation regions by using a wet chemical process using the second mask layer, and causing the surface of the isolation region to be recessed into the silicon substrate relative to the surface of each of the second regions, where a process temperature of the wet chemical process is greater than or equal to 60°C and less than or equal to 80°C; and/or a process time of the wet chemical process is greater than or equal to 50s and less than or equal to 300s; and/or a wet chemical etching solution used in the wet chemical process is an alkaline wet chemical etching solution, and a volume proportion of an alkaline component in the alkaline wet chemical etching solution is greater than or equal to 2% and less than or equal to 20%; and/or the wet chemical etching solution used in the wet chemical process includes a polishing additive, and a volume proportion of the polishing additive in the wet chemical etching solution is greater than or equal to 0.5% and less than or equal to 5%.

In a case that the foregoing technical solution is used, both the process temperature and the process time of the wet chemical process affect a depth by which the surface of the isolation region is caused to be recessed into the silicon substrate relative to the surface of each of the second regions through the wet chemical process. Based on this, when the process temperature of the wet chemical process falls within the foregoing range, a small depth by which the surface of the isolation region is recessed into the silicon substrate relative to the surface of each of the second regions caused by a low process temperature can be prevented. In addition, a large depth by which the surface of the isolation region is recessed into the silicon substrate relative to the surface of each of the second regions caused by a high process temperature can also be prevented. For beneficial effects of preventing the depth by which the surface of the isolation region is recessed into the silicon substrate relative to the surface of each of the second regions from being excessively small and excessively large, reference may be made to the foregoing content. Besides, beneficial effects of the process time and the volume proportion of the alkaline component falling with the foregoing ranges are similar to the beneficial effects that the process temperature is greater than or equal to 60°C and less than or equal to 80°C, and details are not described herein again. In addition, when the volume proportion of the polishing additive in the wet chemical etching solution falls within the foregoing range, the flatness of the surface of the isolation region after this operation can be improved, thereby further improving a passivation effect of the surface passivation layer on the isolation region.

In a possible implementation, after the providing a silicon substrate and before the forming a first doped semiconductor layer on the first regions, the method for manufacturing a back contact solar cell further includes: forming a first passivation layer on the first regions.

In a possible implementation, after the causing a surface of the isolation region and a surface of each of the second regions to be recessed into the silicon substrate relative to a surface of each of the first regions and before the forming a second doped semiconductor layer on the second regions, the method for manufacturing a back contact solar cell further includes: forming a second passivation layer on the second regions.

In a possible implementation, after the causing the surface of the isolation region to be recessed into the silicon substrate relative to the surface of each of the second regions, the method for manufacturing a back contact solar cell further includes: forming a surface passivation layer covering the first doped semiconductor layer, the second doped semiconductor layer, and the isolation regions.

For beneficial effects of the second aspect and various implementations of the second aspect in the present invention, reference may be made to the analysis of the beneficial effects of the first aspect and various implementations of the first aspect, and details are not described herein again.

### BRIEF DESCRIPTION OF THE DRAWINGS

The accompanying drawings described herein are used to provide a further understanding of the present invention, and form a part of the present invention. Exemplary embodiments of the present invention and description thereof are used to explain the present invention, and do not constitute any inappropriate limitation to the present invention. In the accompanying drawings:
FIG. 1 is a longitudinal cross-sectional SEM image of a back contact solar cell in the related art;
FIG. 2 is a schematic longitudinal cross-sectional view of a structure of a back contact solar cell according to an embodiment of the present invention;
FIG. 3 is a first SEM image of a partial structure of a back contact solar cell according to an embodiment of the present invention;
FIG. 4 is a second SEM image of a partial structure of a back contact solar cell according to an embodiment of the present invention;
FIG. 5 is a third SEM image of a partial structure of a back contact solar cell according to an embodiment of the present invention;
FIG. 6 is a fourth SEM image of a partial structure of a back contact solar cell according to an embodiment of the present invention;
FIG. 7 is a fifth SEM image of a partial structure of a back contact solar cell according to an embodiment of the present invention;
FIG. 8 is a first schematic structural diagram of a back contact solar cell in a manufacturing procedure according to an embodiment of the present invention;
FIG. 9 is a second schematic structural diagram of a back contact solar cell in a manufacturing procedure according to an embodiment of the present invention;
FIG. 10 is a third schematic structural diagram of a back contact solar cell in a manufacturing procedure according to an embodiment of the present invention;
FIG. 11 is a fourth schematic structural diagram of a back contact solar cell in a manufacturing procedure according to an embodiment of the present invention;
FIG. 12 is a fifth schematic structural diagram of a back contact solar cell in a manufacturing procedure according to an embodiment of the present invention;
FIG. 13 is a sixth schematic structural diagram of a back contact solar cell in a manufacturing procedure according to an embodiment of the present invention;
FIG. 14 is a seventh schematic structural diagram of a back contact solar cell in a manufacturing procedure according to an embodiment of the present invention;
FIG. 15 is an eighth schematic structural diagram of a back contact solar cell in a manufacturing procedure according to an embodiment of the present invention;
FIG. 16 is a ninth schematic structural diagram of a back contact solar cell in a manufacturing procedure according to an embodiment of the present invention;
FIG. 17 is a tenth schematic structural diagram of a back contact solar cell in a manufacturing procedure according to an embodiment of the present invention;
FIG. 18 is an eleventh schematic structural diagram of a back contact solar cell in a manufacturing procedure according to an embodiment of the present invention;
FIG. 19 is a twelfth schematic structural diagram of a back contact solar cell in a manufacturing procedure according to an embodiment of the present invention;
FIG. 20 is a thirteenth schematic structural diagram of a back contact solar cell in a manufacturing procedure according to an embodiment of the present invention; and
FIG. 21 is a fourteenth schematic structural diagram of a back contact solar cell in a manufacturing procedure according to an embodiment of the present invention;
FIG. 22 is a top view schematic diagram of a back contact battery provided by an embodiment of the present invention.

List of reference numerals: 11-Silicon substrate, 12-First doped semiconductor layer, 13-Second doped semiconductor layer, 14-First region, 15-Second region, 16-Isolation region, 17-Surface passivation layer, 18-First passivation layer, 19-Second passivation layer, 20-First mask layer, 21-Second mask layer, 22-First intrinsic semiconductor layer, 23-First doped silicate glass layer, 24-Second intrinsic semiconductor layer, and 25-Second doped silicate glass layer.

### DETAILED DESCRIPTION

Embodiments of the present disclosure are described below with reference to the accompanying drawings. However, it should be understood that, the description is merely exemplary, and is not intended to limit the scope of the present disclosure. In addition, in the following description, description of well-known structures and technologies are omitted, to avoid unnecessarily obscuring the concept of the present disclosure.

The accompanying drawings show various schematic structural diagrams according to the embodiments of the present disclosure. The accompanying drawings are not drawn to scale, some details are enlarged for the purpose of clarity, and some details may be omitted. Shapes of various regions and layers shown in the drawings, and relative sizes and positional relationships between the various regions and layers are merely exemplary, and may deviate in practice due to manufacturing tolerances or technical limitations, and a person skilled in the art may additionally design regions/layers with different shapes, sizes, and relative positions according to actual requirements.

In the context of the present disclosure, when a layer/element is referred to as being "on" another layer/element, the layer/element may be directly on the another layer/element, or an intermediate layer/element may exist between the layer/element and the another layer/element. In addition, if one layer/element is "above" another layer/element in an orientation, when the orientation is turned, the layer/element may be "below" the another layer/element. To make the technical problems to be resolved by, the technical solutions, and the beneficial effects of the present invention clearer and more comprehensible, the following describes the present invention in further detail with reference to the accompanying drawings and embodiments. It should be understood that, the specific embodiments described herein are merely used for describing the present invention and are not intended to limit the present invention.

In addition, the terms "first" and "second" are used merely for the purpose of description, and shall not be construed as indicating or implying relative importance or implying a quantity of indicated technical features. Therefore, a feature defined by "first" or "second" may explicitly indicate or implicitly include one or more features. In the description of the present invention, "a plurality of" means two or more, unless otherwise definitely and specifically limited. "Several" means one or more, unless otherwise definitely and specifically limited.

In the description of the present invention, it should be noted that, unless otherwise explicitly specified and defined, the terms such as "mount", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, internal communication between two elements, or an interactive relationship between two elements. A person of ordinary skill in the art can understand specific meanings of the terms in the present invention based on specific situations.

At present, solar cells are increasingly widely used as a new energy alternative solution. A photovoltaic solar cell is an apparatus converting sun's light energy into electric energy. Specifically, the solar cell generates carriers by using the photovoltaic principle, and leads the carriers out by using electrodes, thereby facilitating the effective use of the electric energy.

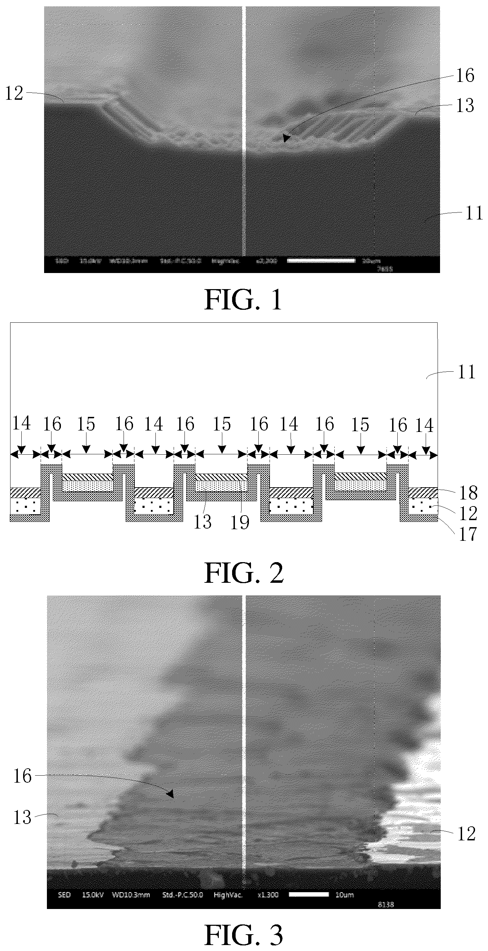

When a positive electrode and a negative electrode included in the solar cell are both located on a back surface of the solar cell, the solar cell is a back contact solar cell. A light receiving surface of the back contact solar cell is not blocked by any metal electrode. Therefore, compared with a solar cell with a metal electrode arranged on its light receiving surface, the back contact solar cell has a higher short-circuit current and photoelectric conversion efficiency, and is one of existing technical directions for realizing efficient crystalline silicon solar cells. Specifically, as shown in FIG. 1, an existing back contact solar cell generally includes: a silicon substrate 11, and a first doped semiconductor layer 12 and a second doped semiconductor layer 13 alternately distributed at intervals on a back surface of the silicon substrate 11. A conductivity type of the first doped semiconductor layer 12 is opposite to a conductivity type of the second doped semiconductor layer 13.

In an actual manufacturing procedure, a first doped semiconductor layer entirely arranged is generally formed on the back surface. Selective etching is performed on the first doped semiconductor layer to only reserve the first doped semiconductor layer on some regions of the back surface. A second doped semiconductor layer is then formed on the first doped semiconductor layer and a part of the back surface exposed to the first doped semiconductor layer, and selective etching is performed on the second doped semiconductor layer, so that the first doped semiconductor layer and the second doped semiconductor layer are alternately distributed at intervals on the back surface of the silicon substrate.

However, as shown in FIG. 1, the conductivity type of the first doped semiconductor layer 12 is opposite to the conductivity type of the second doped semiconductor layer 13, to prevent short circuit caused by electrical connection between the first doped semiconductor layer 12 and the second doped semiconductor layer 13, an isolation region 16 with a specific width is formed between the two doped semiconductor layers in a wet chemical etching manner in existing manufacturing methods. However, in an existing back contact solar cell, a depth by which the isolation region 16 between the first doped semiconductor layer 12 and the second doped semiconductor layer 13 is recessed into the silicon substrate 11 is relatively large (greater than 5 µm), carriers in the silicon substrate 11 can be collected by the first doped semiconductor layer 12 and the second doped semiconductor layer 13 respectively only after bypassing the isolation region with a large depth, leading to large movement distances of the carriers, and further leading to low carrier collection efficiency and a large carrier recombination rate, which is not conducive to improving the operating performance of the back contact solar cell.

To resolve the foregoing technical problems, according to a first aspect, an embodiment of the present invention provides a back contact solar cell. As shown in FIG. 2, the back contact solar cell provided in this embodiment of the present invention includes: a silicon substrate 11, and a first doped semiconductor layer 12 and a second doped semiconductor layer 13 alternately distributed at intervals on a back surface of the silicon substrate 11. A conductivity type of the first doped semiconductor layer 12 is opposite to a conductivity type of the second doped semiconductor layer 13. In the back surface of the silicon substrate 11, regions corresponding to the first doped semiconductor layer 12 are defined as first regions 14, regions corresponding to the second doped semiconductor layer 13 are defined as second regions 15, and a region located between each first region 14 and a second region 15 adjacent to the first region is defined as an isolation region 16, where a plurality of isolation regions 16 are provided. A surface of each of the second regions 15 is recessed into the silicon substrate 11 relative to a surface of each of the first regions 14. A surface of the isolation region 16 is recessed into the silicon substrate 11 relative to the surface of each of the second regions 15, and a depth by which the surface of the isolation region 16 is recessed into the silicon substrate 11 relative to the surface of each of the first regions 14 is less than 3000 nm.

In a case that the foregoing technical solution is used, as shown in FIG. 2, in the back contact solar cell provided in this embodiment of the present invention, the first doped semiconductor layer 12 and the second doped semiconductor layer 13 having opposite conductivity types are alternately distributed at intervals on the back surface of the silicon substrate 11. Based on this, the isolation region 16 on the back surface of the silicon substrate 11 can separate the first doped semiconductor layer 12 from the second doped semiconductor layer 13, thereby reducing a carrier recombination rate at a lateral junction of the first doped semiconductor layer 12 and the second doped semiconductor layer 13, which helps improve the photoelectric conversion efficiency of the back contact solar cell. Besides, the first doped semiconductor layer 12 is formed on the first regions 14 of the back surface, and the second doped semiconductor layer 13 is formed on the second regions 15 of the back surface. Therefore, when the surface of each of the second regions 15 is recessed into the silicon substrate 11 relative to the surface of each of the first regions 14, and the surface of the isolation region 16 is recessed into the silicon substrate 11 relative to the surface of each of the second regions 15, it indicates that after selective etching is performed on a first doped semiconductor layer 12 entirely covering the back surface in an actual manufacturing procedure, not only parts of the first doped semiconductor layer 12 located on the second regions 15 and the isolation regions 16 are completely removed, but also the silicon substrate 11 of a partial thickness is further etched, to ensure that no first doped semiconductor layer 12 remains on the second regions 15 and the isolation regions 16, thereby preventing short circuit. In addition, the first doped semiconductor layer 12 and the second doped semiconductor layer 13 located on the back surface of the silicon substrate 11 and having opposite conductivity types can be at least partially staggered from each other along a thickness direction of the silicon substrate 11, thereby further reducing a risk of current leakage on the back surface, and improving the electrical reliability of the back contact solar cell. Similarly, when the surface of the isolation region 16 is recessed into the silicon substrate 11 relative to the surface of each of the second regions 15, it indicates that after selective etching is performed on the second doped semiconductor layer 13 deposited on the first doped semiconductor layer 12, the second regions 15, and the isolation regions 16 in an actual manufacturing procedure, not only parts of the second doped semiconductor layer 13 located on the first doped semiconductor layer 12 and the isolation regions 16 are completely removed, but also the silicon substrate 11 of a partial thickness corresponding to the isolation region 16 is further etched, to ensure that no second doped semiconductor layer 13 remains on the first doped semiconductor layer 12 and the isolation regions 16, thereby preventing short circuit. In addition, it can be learned from the foregoing content that, in the back surface of the silicon substrate 11, a depth by which the isolation region 16 is recessed into the silicon substrate 11 is largest, and the depth by which the isolation region 16 is recessed into the silicon substrate 11 relative to the surface of each of the first regions 14 is less than 3000 nm. Based on this, compared with the related art in which the isolation region is recessed into the silicon substrate by more than 5 µm, in the back contact solar cell provided in this embodiment of the present invention, the isolation region 16 is recessed into the silicon substrate 11 by a smaller depth. In this case, carriers of a corresponding conductivity type can be collected by the first doped semiconductor layer 12 or the second doped semiconductor layer 13 without bypassing an isolation region 16 with a large depth, so that movement distances of some carriers can be shortened, and the carrier collection efficiency can be improved, helping improve the operating performance of the back contact solar cell.

In an actual application procedure, as shown in FIG. 2, a light receiving surface of the silicon substrate 11 may be a planar surface. Alternatively, the light receiving surface of the silicon substrate may be a textured surface. Because the textured surface has a light trapping effect, when the light receiving surface of the silicon substrate is the textured surface, the reflectivity of the light receiving surface can be reduced, which helps enable more light to be refracted from the light receiving surface into the silicon substrate and be absorbed and utilized by the silicon substrate, thereby improving the photoelectric conversion efficiency of the back contact solar cell.

In addition, in terms of a range, boundaries of the first regions, the second regions, and the isolation region on the back surface of the silicon substrate are virtual boundaries. As shown in FIG. 2, the first doped semiconductor layer 12 is formed on the first regions 14, so that a range of the first regions 14 on the back surface of the silicon substrate 11 can be determined according to a formation range requirement on the first doped semiconductor layer 12 in an actual application scenario. Secondly, the second doped semiconductor layer 13 is formed on the second regions 15, so that a range of the second regions 15 on the back surface of the silicon substrate 11 can be determined according to a formation range requirement on the second doped semiconductor layer 13 in an actual application scenario. As for the isolation region 16, as described above, the isolation region 16 can separate the first doped semiconductor layer 12 and the second doped semiconductor layer 13 having opposite conductivity types from each other, thereby suppressing current leakage. Therefore, a range of the isolation region 16 on the back surface can be determined according to a requirement on a current leakage gap between the first doped semiconductor layer 12 and the second doped semiconductor layer 13 in an actual application scenario.

For example, a length of the isolation region along an arrangement direction of the first regions and the second regions is greater than or equal to 20 µm and less than or equal to 110 µm. For example, the length of the isolation region may be 20 µm, 40 µm, 60 µm, 80 µm, 100 µm, or 110 µm. In this case, when the length of the isolation region falls within the foregoing range, current leakage between the first doped semiconductor layer and the second doped semiconductor layer caused by a small gap can be prevented, thereby ensuring high electrical reliability of the back contact solar cell. In addition, it can also be prevented that carriers on the back surface cannot be collected by the first doped semiconductor layer and/or the second doped semiconductor layer in time and led out by corresponding electrodes in a case that formation ranges of the first doped semiconductor layer and/or the second doped semiconductor layer on the back surface are small due to a large gap, thereby further reducing the carrier recombination rate on the back surface.

In terms of a recessed depth, depths by which the surface of each of the second regions and the surface of the isolation region on the back surface of the silicon substrate are respectively recessed into the silicon substrate and a height difference between the surface of each of the second regions and the surface of the isolation region may be determined according to an actual application scenario, provided that the surface of each of the second regions is recessed inward relative to the surface of each of the first regions, the surface of the isolation region is recessed inward relative to the surface of each of the second regions, and the depth by which the surface of the isolation region is recessed into the silicon substrate relative to the surface of each of the first regions is less than 3000 nm.

For example, a depth by which the surface of each of the second regions is recessed into the silicon substrate may be greater than or equal to 100 nm and less than or equal to 1000 nm. For example, the depth by which the surface of each of the second regions is recessed into the silicon substrate may be 100 nm, 300 nm, 600 nm, 800 nm, 900 nm, or 1000 nm. In this case, when the depth by which the surface of each of the second regions is recessed into the silicon substrate falls within the foregoing range, it can be prevented that a degree at which the first doped semiconductor layer and the second doped semiconductor layer located on the back surface of the silicon substrate and having opposite conductivity types are staggered from each other is small along the thickness direction of the silicon substrate caused by a small depth by which the surface of each of the second regions is recessed into the silicon substrate, thereby further reducing the risk of current leakage on the back surface. In addition, the isolation region is recessed into the silicon substrate relative to each of the second regions, that is, compared with the second region, the depth by which the isolation region is recessed into the silicon substrate is larger. Therefore, when the depth by which the surface of each of the second regions is recessed into the silicon substrate falls within the foregoing range, it can be prevented that the depth by which the isolation region is recessed into the silicon substrate becomes larger caused by a large depth by which the surface of each of the second regions is recessed into the silicon substrate, thereby ensuring that movement distances of some carriers bypassing the isolation region and being transmitted to the first doped semiconductor layer or the second doped semiconductor layer are relatively small. In addition, it can also be prevented that a silicon substrate with a large thickness needs to be used due to large depths by which each of the second regions and the isolation region are recessed into the silicon substrate, so that production of a thin back contact solar cell can be implemented while manufacturing costs of the back contact solar cell can be reduced.

For example, the height difference between the surface of each of the second regions and the surface of the isolation region may be greater than or equal to 300 nm and less than 2000 nm. For example, the height difference between the surface of each of the second regions and the surface of the isolation region may be 300 nm, 600 nm, 900 nm, 1200 nm, 1500 nm, 1800 nm, or 2000 nm. In this case, when the height difference between the surface of each of the second regions and the surface of the isolation region falls within the foregoing range, it can be prevented that an etching depth of an etchant to the isolation region of the silicon substrate can be small only by strictly controlling an etching time after a part of the second doped semiconductor layer on the isolation region is completely removed in an actual manufacturing procedure due to a small height difference, thereby reducing the etching difficulty. It can also be prevented that a reduction degree of movement distances of carriers of a corresponding conductivity type is not apparent caused by a large height difference, thereby ensuring that the carrier collection efficiency can be improved.

As for the depth by which the isolation region is recessed into the silicon substrate, the depth may be any value greater than the depth by which the surface of each of the second regions is recessed into the silicon substrate and less than 3000 nm. For example, in a case that the depth by which the surface of each of the second regions is recessed into the silicon substrate is 500 nm, the depth by which the isolation region is recessed into the silicon substrate relative to the surface of each of the first regions may be any value (for example, 1000 nm, 1500 nm, 1800 nm, 2000 nm, 2500 nm, 2800 nm, or 2900 nm) greater than 500 nm and less than 3000 nm.

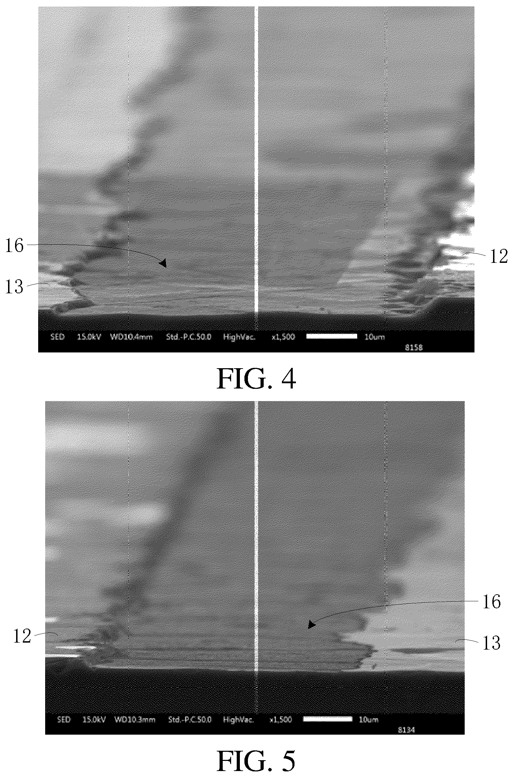

In terms of a surface topography, as shown in FIG. 2, in the back surface of the silicon substrate 11, the surface of each of the first regions 14 is a planar surface; and the surface of each of the second regions 15 may be a planar surface or a textured surface. As shown in FIG. 2 to FIG. 7, when the surface of each of the second regions 15 is a planar surface, the surface of each of the second regions 15 is relatively flat, which helps improve the formation quality of the second doped semiconductor layer 13 formed on each of the second regions 15. In addition, a surface of the second doped semiconductor layer 13 formed on each of the second regions 15 is similar to a height fluctuation of the surface of each of the second regions 15. Therefore, when the surface of each of the second regions 15 is a planar surface, it further helps improve the surface flatness of a side of the second doped semiconductor layer 13 facing away from the silicon substrate 11. Based on this, when the back contact solar cell further includes a surface passivation layer 17, compared with a textured surface, a thickness of a part of the surface passivation layer 17 formed on the second doped semiconductor layer 13 whose surface has relatively high flatness is greater, which can improve a passivation effect of the surface passivation layer 17 on the side of the second doped semiconductor layer 13 facing away from the silicon substrate 11, thereby further reducing the carrier recombination rate on the back surface of the back contact solar cell and helping improve the photoelectric conversion efficiency of the back contact solar cell.

As for the isolation region, as shown in FIG. 2 to FIG. 7, the surface of the isolation region 16 may be a planar surface or a textured surface. As shown in FIG. 2 to FIG. 7, in a case that the surface of the isolation region 16 is a planar surface, the surface of the isolation region 16 is relatively flat. Based on this, when the back contact solar cell further includes a surface passivation layer 17, compared with a textured surface, a thickness of a part of the surface passivation layer 17 formed on the isolation region 16 whose surface is planar is greater, which can improve a passivation effect of the surface passivation layer 17 on the isolation region 16, thereby reducing a carrier recombination rate on the surface of the isolation region 16 and helping improve the photoelectric conversion efficiency of the back contact solar cell. Specifically, a surface roughness of the isolation region 16 may be determined according to a requirement for a passivation effect of the surface passivation layer 17 on the isolation region 16 in an actual application scenario and an actual manufacturing procedure. This is not specifically limited herein.

When the surface of the isolation region is a textured surface, a recessed depth of the isolation region may be a depth by which a top portion of the textured surface of the isolation region is recessed into the silicon substrate relative to the surface of each of the first regions, or may be a depth by which a bottom portion of the textured surface of the isolation region is recessed into the silicon substrate relative to the surface of each of the first regions. In at least one of the foregoing cases, the recessed depth of the isolation region is less than 3000 nm.

For example, a roughness of the surface of the isolation region may be less than or equal to 30 µm per 10000 square micrometers (100 micrometer×100 micrometer). For example, the roughness of the surface of the isolation region may be 5 µm, 10 µm, 12 µm, 15 µm, 18 µm, 20 µm, 22 µm, 25 µm, or 30 µm per 10000 square micrometers. Beneficial effects in this case are similar to the beneficial effects when the surface of the isolation region is a planar surface, and details are not described herein again.

When the surface of each of the second regions or the isolation region is a textured surface, a size of a textured structure on the surface may be determined according to a depth by which the textured surface is recessed into the silicon substrate, which is not specifically limited herein. It may be understood that, within a specific range, a smaller depth by which the textured surface is recessed into the silicon substrate indicates a smaller size of the textured structure on the surface. In addition, it should be noted that, when the surface of each of the second regions or the isolation region is a textured surface, the depth by which the surface of each of the second regions or the isolation region is recessed into the silicon substrate is equal to a vertical distance between a middle portion of the textured surface of each of the second regions or the isolation region and the surface of each of the first regions.

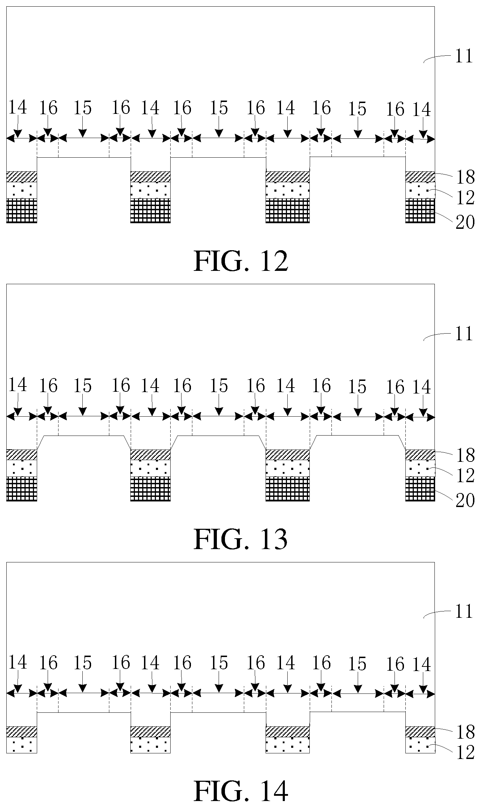

As for a morphology of side walls of the isolation region, as shown in FIG. 2, the side walls of the isolation region 16 may be arranged perpendicular to a horizontal plane. Alternatively, as shown in FIG. 13, at least part of a surface in side walls of the isolation region 16 is arranged obliquely relative to a horizontal plane, so that a cross-sectional area of at least part of the isolation region 16 gradually increases along a direction from the light receiving surface to the back surface. In this case, when a cross-sectional area of a side of the isolation region 16 close to the light receiving surface is less than a cross-sectional area of a side of the isolation region close to the back surface, a gap between a first doped semiconductor layer 12 and a second doped semiconductor layer 13 having a conductivity type opposite to that of the first doped semiconductor layer can be increased, thereby reducing the risk of current leakage on the back surface of the back contact solar cell and ensuring high electrical reliability of the back contact solar cell. In addition, the part in the side walls of the isolation region 16 arranged obliquely relative to the horizontal plane also helps reflect light, so that more light enters the silicon substrate 11 from the back surface of the back contact solar cell under a reflection effect of the part in the side walls of the isolation region 16 arranged obliquely relative to the horizontal plane, thereby improving the photoelectric conversion efficiency of the back contact solar cell.

In the foregoing case, an included angle between the part in the side walls of the isolation region arranged obliquely relative to the horizontal plane and the horizontal plane may be determined according to an actual manufacturing procedure and a reflection requirement on the side walls, which is not specifically limited herein.

For example, the included angle between the part in the side walls of the isolation region arranged obliquely relative to the horizontal plane and the horizontal plane may be less than or equal to 52° and greater than or equal to 58°. For example, the included angle between the part in the side walls of the isolation region arranged obliquely relative to the horizontal plane and the horizontal plane may be 52°, 53°, 54°, 55°, 56°, 57°, or 58°. In this case, when the included angle falls within the foregoing range, it may be ensured that more light can enter the silicon substrate and be utilized by the silicon substrate under the large reflection effect of the part in the side walls of the isolation region arranged obliquely relative to the horizontal plane, thereby further improving the utilization of light by the back contact solar cell.

For the first doped semiconductor layer and the second doped semiconductor layer, in terms of a material, a material of the first doped semiconductor layer or the second doped semiconductor layer may include a semiconductor material such as silicon, silicon germanium, germanium, or gallium arsenide. In terms of arrangement of substances, a crystalline phase of the first doped semiconductor layer or the second doped semiconductor layer may be an amorphous semiconductor layer, a microcrystalline semiconductor layer, a nanocrystalline semiconductor layer, a monocrystalline semiconductor layer, or a polycrystalline semiconductor layer. In terms of a conductivity type, the conductivity type of the first doped semiconductor layer or the second doped semiconductor layer may be opposite to a conductivity type of the silicon substrate or may be the same as a conductivity type of the silicon substrate, provided that the conductivity type of the first doped semiconductor layer is opposite to the conductivity type of the second doped semiconductor layer. A thickness of the first doped semiconductor layer and a thickness of the second doped semiconductor layer may be set according to an actual requirement, which are not specifically limited herein. For example, the thickness of the first doped semiconductor layer or the thickness of the second doped semiconductor layer may be greater than or equal to 100 nm and less than or equal to 500 nm.

In an actual application procedure, the first doped semiconductor layer may be directly formed on the first regions of the silicon substrate. Alternatively, as shown in FIG. 2, the back contact solar cell further includes a first passivation layer 18 between the first regions 14 of the silicon substrate 11 and the first doped semiconductor layer 12. In this case, the first passivation layer 18 and the first doped semiconductor layer 12 may form a selective contact structure to perform chemical passivation on the first regions 14 on the back surface of the silicon substrate 11 and selectively collect carriers of a corresponding conductivity type, thereby reducing the carrier recombination rate on the back surface and helping improve the photoelectric conversion efficiency of the back contact solar cell.

Specifically, a material of the first passivation layer may be determined according to the material of the first doped semiconductor layer and a type of the selective contact structure formed by the first passivation layer and the first doped semiconductor layer in an actual application scenario, which is not specifically limited herein.

For example, when the selective contact structure formed by the first passivation layer and the first doped semiconductor layer is a tunneling passivation contact structure, the first doped semiconductor layer is a doped polysilicon layer, and the first passivation layer is a tunneling passivation layer. A material of the tunneling passivation layer may include silicon oxide, aluminum oxide, titanium oxide, or other materials.

For another example, when the selective contact structure formed by the first passivation layer and the first doped semiconductor layer is a heterogeneous contact structure, the first doped semiconductor layer is a doped amorphous silicon layer and/or a doped microcrystalline silicon layer, and the first passivation layer is an intrinsic amorphous silicon layer and/or an intrinsic microcrystalline silicon layer.

A thickness of the first passivation layer may be set according to an actual requirement, which is not specifically limited herein. For example, the thickness of the first passivation layer may be greater than or equal to 0.5 nm and less than or equal to 3 nm.

For the second doped semiconductor layer, the second doped semiconductor layer may be directly formed on the second regions of the silicon substrate. Alternatively, as shown in FIG. 2, the back contact solar cell further includes a second passivation layer 19 between the second regions 15 of the silicon substrate 11 and the second doped semiconductor layer 13. In this case, the second passivation layer 19 and the second doped semiconductor layer 13 may form a selective contact structure to perform chemical passivation on the second regions 15 on the back surface of the silicon substrate 11 and selectively collect carriers of a corresponding conductivity type, thereby reducing the carrier recombination rate on the back surface and helping improve the photoelectric conversion efficiency of the back contact solar cell.

Specifically, for a material and a thickness of the second passivation layer, reference may be made to the material and the thickness of the first passivation layer described above, and details are not described herein again.

In terms of a morphology, a morphology of a side surface of each of the first doped semiconductor layer and the second doped semiconductor layer close to the isolation region is not specifically limited in the embodiments of the present invention, provided that the morphology of the side surface can be applied to the back contact solar cell provided in the embodiments of the present invention. For example, the side surface of each of the first doped semiconductor layer and/or the second doped semiconductor layer close to the isolation region may be in a shape of a straight line, a broken line, an arc, or a wave. The morphology of the side surface of the first doped semiconductor layer close to the isolation region and the morphology of the side surface of the second doped semiconductor layer close to the isolation region may be the same or may be different.

In an actual application procedure, as shown in FIG. 3 to FIG. 7, a side surface of each of the first doped semiconductor layer 12 and the second doped semiconductor layer 13 close to the isolation region 16 may be wave-shaped. In addition, a fluctuation amplitude corresponding to the side surface of the second doped semiconductor layer 13 close to the isolation region 16 may be greater than a fluctuation amplitude corresponding to the side surface of the first doped semiconductor layer 12 close to the isolation region 16; and a fluctuation frequency corresponding to the side surface of the second doped semiconductor layer 13 close to the isolation region 16 may be less than a fluctuation frequency corresponding to the side surface of the first doped semiconductor layer 12 close to the isolation region 16. In this case, when the fluctuation amplitude corresponding to the side surface of the second doped semiconductor layer 13 close to the isolation region 16 is greater than the fluctuation amplitude corresponding to the side surface of the first doped semiconductor layer 12 close to the isolation region 16, a roughness of a local region of the side surface of the second doped semiconductor layer 13 close to the isolation region 16 is less than a roughness of a local region of the side surface of the first doped semiconductor layer 12 close to the isolation region 16, thereby helping reduce a quantity of defects of a part of the second doped semiconductor layer 13 formed close to the isolation region 16, reducing a carrier recombination rate at the part of the second doped semiconductor layer 13 close to the isolation region 16, and further improving the operating performance of the back contact solar cell.

The fluctuation amplitude corresponding to the side surface of each of the first doped semiconductor layer and the second doped semiconductor layer close to the isolation region is a fluctuation amplitude of a protruding portion of the side surface relative to a lowest point of a recessed portion of the side surface. In addition, the fluctuation frequency corresponding to the side surface of each of the first doped semiconductor layer and the second doped semiconductor layer close to the isolation region is a frequency of occurrence of different protruding portions of the side surface. Specifically, when the side surfaces of the first doped semiconductor layer and the second doped semiconductor layer close to the isolation region are all wave-shaped, the fluctuation amplitudes and the fluctuation frequencies of the side surfaces of the first doped semiconductor layer and the second doped semiconductor layer close to the isolation region may be determined according to an actual manufacturing procedure, which are not specifically limited herein.

In a possible implementation, as shown in FIG. 2, the back contact solar cell may further include a surface passivation layer 17 covering the first doped semiconductor layer 12, the second doped semiconductor layer 13, and the isolation regions 16. In this case, the surface passivation layer 17 may passivate the back surface of the back contact solar cell, thereby reducing the carrier recombination rate on the back surface. In addition, the recessed depth corresponding to the isolation region 16 with the largest recessed depth into the silicon substrate 11 is less than 3000 nm, so that a height fluctuation of each region on the back surface of the back contact solar cell is small, helping increase a formation thickness of the surface passivation layer 17 on the back surface and improve a passivation effect of the surface passivation layer 17 on the back surface.

Specifically, a material of the surface passivation layer may include any insulating material having a passivation effect such as silicon oxide, aluminum oxide, or silicon nitride. A thickness of the surface passivation layer may be determined according to an actual application scenario, which is not specifically limited herein.

According to a second aspect, an embodiment of the present invention provides a method for manufacturing a back contact solar cell. The following describes a manufacturing procedure with reference to cross-sectional views of operations shown in FIG. 2 to FIG. 21. Specifically, the method for manufacturing a back contact solar cell includes the following steps:
First, a silicon substrate is provided, where a back surface of the silicon substrate includes first regions and second regions alternately distributed at intervals and an isolation region located between each first region and a second region adjacent to the first region;
Specifically, for ranges of the first regions, the second regions, and the isolation region on the back surface, reference may be made to the foregoing content, and details are not described herein again.

Next, as shown in FIG. 12 to FIG. 14, a first doped semiconductor layer 12 is formed on the first regions 14, and a surface of the isolation region 16 and a surface of each of the second regions 15 are caused to be recessed into the silicon substrate 11 relative to a surface of each of the first regions 14.

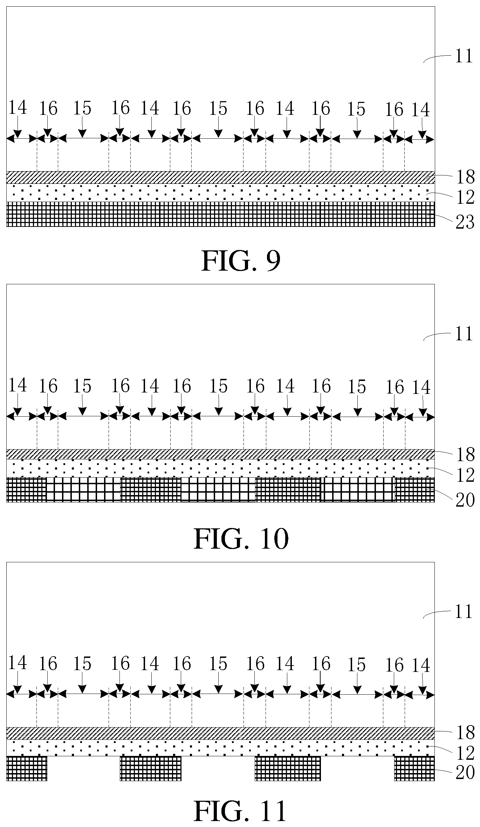

In an actual manufacturing procedure, as shown in FIG. 11, after the silicon substrate 11 is provided, a first doped semiconductor layer 12 entirely arranged on the back surface of the silicon substrate 11 and a first mask layer 20 located on parts of the first doped semiconductor layer 12 corresponding to the first regions 14 are formed. Then, as shown in FIG. 12 and FIG. 13, parts of the first doped semiconductor layer 12 located on the isolation regions 16 and the second regions 15 are selectively removed using the first mask layer 20, and the surface of the isolation region 16 and the surface of each of the second regions 15 are caused to be recessed into the silicon substrate 11 relative to the surface of each of the first regions 14.

For a material and a thickness of the first doped semiconductor layer and depths by which the surface of the isolation region and the surface of each of the second regions are respectively recessed into the silicon substrate after this operation, reference may be made to the foregoing content. As for the first mask layer, a material of the first mask layer may be any material having a masking effect, which is not specifically limited herein. Secondly, formation processes and specific formation procedures of the first doped semiconductor layer and the first mask layer may be determined according to specific materials of the first doped semiconductor layer and the first mask layer.

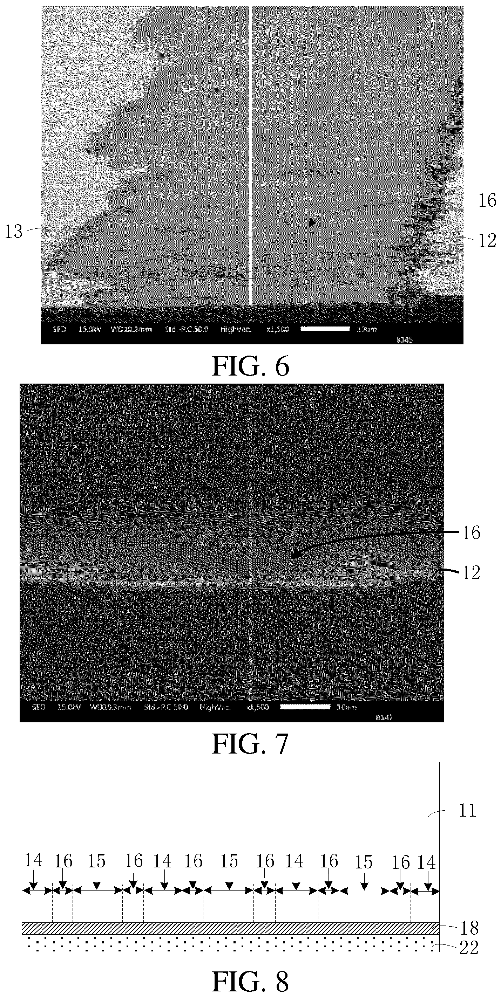

For example, in a case that the material of the first doped semiconductor layer includes silicon, the process of forming a first doped semiconductor layer entirely arranged on the back surface of the silicon substrate and a first mask layer on parts of the first doped semiconductor layer corresponding to the first regions may include the following steps: As shown in FIG. 8, forming a first intrinsic semiconductor layer 22 entirely arranged on the back surface of the silicon substrate 11; next, as shown in FIG. 9, performing doping treatment on the first intrinsic semiconductor layer 22, to form the first intrinsic semiconductor layer 22 into the first doped semiconductor layer 12, and forming a first doped silicate glass layer 23 entirely arranged on the first doped semiconductor layer 12; then, as shown in FIG. 10, performing heat treatment on parts of the first doped silicate glass layer 23 corresponding to the isolation regions 16 and the second regions 15 by using a laser etching process, to form parts of the first doped silicate glass layer 23 on which the heat treatment is not performed into the first mask layer 20; and finally, as shown in FIG. 11, removing the parts of the first doped silicate glass layer 23 on which the heat treatment is performed.

Specifically, that the material of the first doped semiconductor layer includes silicon may refer to that the material of the first doped semiconductor layer includes only silicon; or the material of the first doped semiconductor layer includes both silicon and other semiconductor materials such as silicon germanium. Secondly, in an actual manufacturing procedure, the first intrinsic semiconductor layer entirely arranged on the back surface may be formed by using a chemical vapor deposition process. Next, doping treatment may be performed on the first intrinsic semiconductor layer by using a diffusion process. After the foregoing doping treatment, not only the first doped semiconductor layer can be obtained, but also the first doped silicate glass layer entirely arranged may be formed on the first doped semiconductor layer. Heat treatment is then performed on part of the first doped silicate glass layer by using the laser etching process. In this case, as shown in FIG. 10, the part of the first doped silicate glass layer on which laser treatment is performed has poor density and is easy to remove. A part of the first doped silicate glass layer on which laser treatment is not performed has high density and is not easy to remove. Therefore, after the heat treatment, different parts of the first doped silicate glass layer have different etching selection ratios, and when the first mask layer 20 for patterning the first doped semiconductor layer 12 is obtained, there is no need to additionally form other mask materials and other mask deposition processes to obtain the first mask layer 20, thereby helping reduce the manufacturing costs of the back contact solar cell and simplifying a manufacturing procedure of the back contact solar cell. A specific condition of the laser etching process may be set according to an actual application scenario, which is not specifically limited herein.

For example, a laser used in the laser etching process may be a nanosecond laser, a picosecond laser, or a femtosecond laser. A power of the laser etching process may be greater than or equal to 10 W and less than or equal to 100 W, and a diameter of a laser spot may be greater than or equal to 50 µm and less than or equal to 300 µm.

Certainly, in a case that the material of the first doped semiconductor layer includes silicon or the material of the first doped semiconductor layer does not include silicon, the first doped semiconductor layer entirely arranged on the back surface may alternatively be formed by using processes such as chemical vapor deposition and doping. Then, the first mask layer whose material is silicon nitride or another material having a masking effect may be formed by using processes such as chemical vapor deposition and etching.

In addition, after the first mask layer is formed, the parts of the first doped semiconductor layer located on the isolation regions and the second regions may be selectively removed by using a wet chemical process using the first mask layer, and the surface of the isolation region and the surface of each of the second regions are caused to be recessed into the silicon substrate relative to the surface of each of the first regions, thereby preventing a high-temperature laser from causing damage to the silicon substrate and helping improve a yield of the back contact solar cell. Specifically, a process condition of performing selective etching on the first doped semiconductor layer may be determined according to an etching process used, the material of the first doped semiconductor layer, and the depths by which the surface of the isolation region and the surface of each of the second regions are recessed into the silicon substrate after this operation, which is not specifically limited herein.

For example, when the parts of the first doped semiconductor layer located on the isolation regions and the second regions are selectively removed by using the wet chemical process using the first mask layer and the surface of the isolation region and the surface of each of the second regions are caused to be recessed into the silicon substrate relative to the surface of each of the first regions, a process temperature of the wet chemical process may be greater than or equal to 60°C and less than or equal to 80°C; a process time of the wet chemical process may be greater than or equal to 40s and less than or equal to 200s; and a wet chemical etching solution used in the wet chemical process may be an alkaline wet chemical etching solution, and a volume proportion of an alkaline component (for example, NaOH or KOH) in the alkaline wet chemical etching solution may be greater than or equal to 2% and less than or equal to 20%. For example, the process temperature of the wet chemical process may be 60°C, 70°C, 75°C, 78°C, or 80°C. The process time of the wet chemical process may be 40s, 60s, 80s, 100s, 150s, or 200s. When the wet chemical etching solution used in the wet chemical process is the alkaline wet chemical etching solution, the volume proportion of the alkaline component in the alkaline wet chemical etching solution may be 2%, 3%, 6%, 9%, 12%, 15%, or 20%. In this case, both the process temperature and the process time of the wet chemical process affect the depths by which the surface of the isolation region and the surface of each of the second regions are caused to be recessed into the silicon substrate relative to the surface of each of the first regions through the wet chemical process. Based on this, when the process temperature of the wet chemical process falls within the foregoing range, small depths by which the surface of the isolation region and the surface of each of the second regions are recessed into the silicon substrate relative to the surface of each of the first regions caused by a low process temperature can be prevented. In addition, large depths by which the surface of the isolation region and the surface of each of the second regions are recessed into the silicon substrate relative to the surface of each of the first regions caused by a high process temperature can also be prevented. After this operation, both the depths by which the surface of the isolation region and the surface of each of the second regions are recessed into the silicon substrate relative to the surface of each of the first regions are equal to a depth by which the surface of each of the second regions is recessed into the silicon substrate relative to the surface of each of the first regions in the formed back contact solar cell. For beneficial effects of preventing the depth by which the surface of each of the second regions is recessed into the silicon substrate relative to the surface of each of the first regions from being excessively large and excessively small, reference may be made to the foregoing content. Besides, beneficial effects of the process time and the volume proportion of the alkaline component falling with the foregoing ranges are similar to the beneficial effects that the process temperature is greater than or equal to 60°C and less than or equal to 80°C, and details are not described herein again.

In addition, the flatness of the surface of the isolation region and the surface of each of the second regions after this operation can be improved by adding a polishing additive to the wet chemical etching solution, thereby further improving a passivation effect of the surface passivation layer on the isolation region and the second doped semiconductor layer. Specifically, a component of the polishing additive and a proportion of the polishing additive in the wet chemical etching solution may be determined according to an actual application scenario, which is not specifically limited herein. For example, the polishing additive may include sodium benzoate, a defoaming agent, a surfactant, and the like. A volume proportion of the polishing additive in the wet chemical etching solution may be greater than or equal to 0.5% and less than or equal to 5%.

It should be noted that, when the manufactured back contact solar cell further includes a first passivation layer between the first regions and the first doped semiconductor layer, after the providing a silicon substrate and before the forming a first doped semiconductor layer on the first regions, the method for manufacturing a back contact solar cell further includes the following steps: First, a first passivation layer is formed on the first regions by using a deposition and etching process.

Alternatively, as shown in FIG. 8, after the silicon substrate is provided, a first passivation layer 18 entirely arranged on the back surface may be formed by using a chemical vapor deposition process. As shown in FIG. 11 to FIG. 13, after the first mask layer 20 is formed and selective etching is performed on the first doped semiconductor layer 12 using the first mask layer 20, selective etching is performed on the first passivation layer 18. In this case, there is no need to additionally form a corresponding mask layer for forming the first passivation layer 18, thereby simplifying the manufacturing procedure of the back contact solar cell.

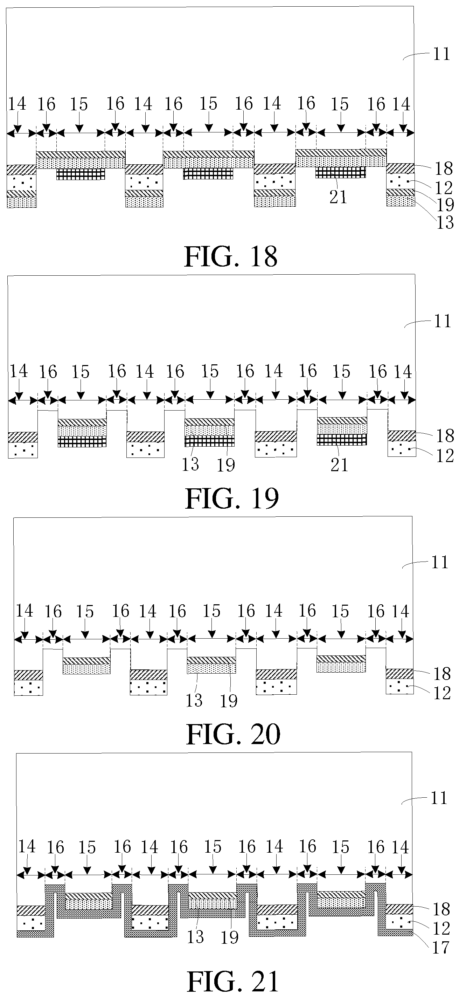

Next, after the surface of the isolation region and the surface of each of the second regions are caused to be recessed into the silicon substrate relative to the surface of each of the first regions, as shown in FIG. 20, a second doped semiconductor layer 13 is formed on the second regions 15, and the surface of the isolation region 16 is caused to be recessed into the silicon substrate 11 relative to the surface of each of the second regions 15, and a depth by which the surface of the isolation region 16 is recessed into the silicon substrate 11 relative to the surface of each of the first regions 14 is caused to be less than 3000 nm.

In an actual manufacturing procedure, as shown in FIG. 18, after the surface of the isolation region 16 and the surface of each of the second regions 15 are caused to be recessed into the silicon substrate 11 relative to the surface of each of the first regions 14, the second doped semiconductor layer 13 may be deposited on the first doped semiconductor layer 12, the isolation regions 16, and the second regions 15, and a second mask layer 21 is formed on parts of the second doped semiconductor layer 13 corresponding to the second regions 15. Next, as shown in FIG. 19, parts of the second doped semiconductor layer 13 corresponding to the first regions 14 and the isolation regions 16 are selectively removed using the second mask layer 21, and the surface of the isolation region 16 is caused to be recessed into the silicon substrate 11 relative to the surface of each of the second regions 15.

Specifically, for a material and a thickness of the second doped semiconductor layer and a depth by which the surface of the isolation region is recessed into the silicon substrate after this operation, reference may be made to the foregoing content, and details are not described herein again. A material of the second mask layer may be any material having a masking effect. In an actual manufacturing procedure, formation processes and specific formation procedures of the second doped semiconductor layer and the second mask layer may be determined according to materials of the second doped semiconductor layer and the second mask layer.

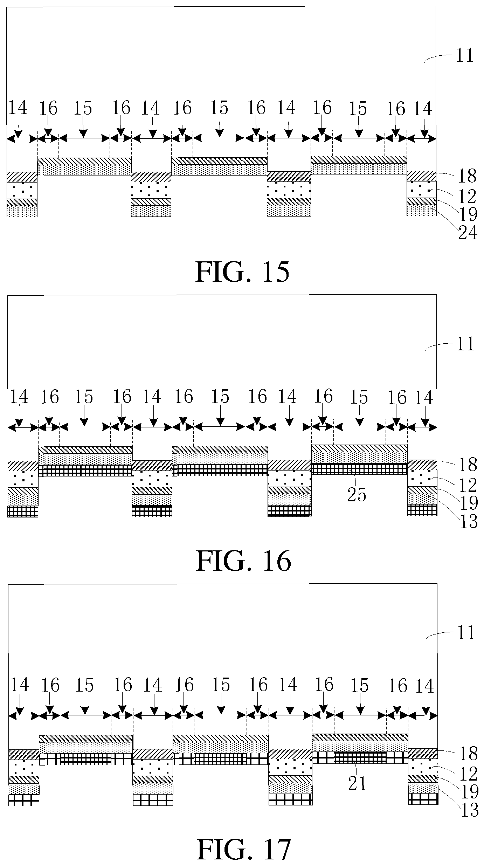

For example, in a case that the material of the second doped semiconductor layer includes silicon, that the second doped semiconductor layer is deposited on the first doped semiconductor layer, the isolation regions, and the second regions, and a second mask layer is formed on parts of the second doped semiconductor layer corresponding to the second regions may include the following steps: As shown in FIG. 15, a second intrinsic semiconductor layer 24 is deposited on the first doped semiconductor layer 12, the isolation regions 16, and the second regions 15. Next, as shown in FIG. 16, doping treatment is performed on the second intrinsic semiconductor layer 24, to form the second intrinsic semiconductor layer 24 into the second doped semiconductor layer 13, and a second doped silicate glass layer 25 entirely arranged on the second doped semiconductor layer 13 is formed. Next, as shown in FIG. 17, heat treatment is performed on parts of the second doped silicate glass layer 25 corresponding to the first regions 14 and the isolation regions 16 by using a laser etching process, to form parts of the second doped silicate glass layer 25 corresponding to the second regions 15 into the second mask layer 21. Finally, as shown in FIG. 18, the parts of the second doped silicate glass layer 25 on which the heat treatment is performed is removed.

Specifically, that the material of the second doped semiconductor layer includes silicon may refer to that the material of the second doped semiconductor layer includes only silicon; or the material of the second doped semiconductor layer includes both silicon and other semiconductor materials such as silicon germanium. Secondly, in an actual manufacturing procedure, a second intrinsic semiconductor layer entirely arranged on the back surface may be formed by using a chemical vapor deposition process. Next, doping treatment may be performed on the second intrinsic semiconductor layer by using a diffusion process. After the foregoing doping treatment, not only the second doped semiconductor layer can be obtained, but also the second doped silicate glass layer entirely arranged may be formed on the second doped semiconductor layer. Heat treatment is then performed on the parts of the second doped silicate glass layer corresponding to the first regions and the isolation regions by using the laser etching process. In this case, the parts of the second doped silicate glass layer on which laser treatment is performed have poor density and are easy to remove. Laser treatment is not performed on the parts of the second doped silicate glass layer corresponding to the second regions. In this case, the parts of the second doped silicate glass layer corresponding to the second regions have high density and are not easy to remove. Therefore, after the heat treatment, different parts of the second doped silicate glass layer have different etching selection ratios, and when the second mask layer for patterning the second doped semiconductor layer is obtained, there is no need to additionally form other mask materials and other mask deposition processes to obtain the second mask layer, thereby helping reduce the manufacturing costs of the back contact solar cell and simplifying a manufacturing procedure of the back contact solar cell. For a specific condition of the laser etching process, reference may be made to the foregoing content, which is not specifically limited herein.

Certainly, in a case that the material of the second doped semiconductor layer includes silicon or the material of the second doped semiconductor layer does not include silicon, a second doped semiconductor layer entirely arranged on the back surface may alternatively be formed by using processes such as chemical vapor deposition and doping. Then, the second mask layer whose material is silicon nitride or another material having a masking effect may be formed by using processes such as chemical vapor deposition and etching.

In addition, after the second mask layer is formed, parts of the second doped semiconductor layer located on the isolation regions and the first doped semiconductor layer may be selectively removed by using a wet chemical process using the second mask layer, and the surface of the isolation region is caused to be recessed into the silicon substrate relative to the surface of each of the second regions, thereby preventing a high-temperature laser from causing damage to the silicon substrate and helping improve a yield of the back contact solar cell. Specifically, a process condition of performing selective etching on the second doped semiconductor layer may be determined according to an etching process used, the material of the second doped semiconductor layer, and the depth by which the surface of the isolation region is recessed into the silicon substrate, which is not specifically limited herein.

For example, when the parts of the second doped semiconductor layer located on the first regions and the isolation regions are selectively removed by using the wet chemical process using the second mask layer and the surface of the isolation region is caused to be recessed into the silicon substrate relative to the surface of each of the second regions, a process temperature of the wet chemical process may be greater than or equal to 60°C and less than or equal to 80°C; a process time of the wet chemical process may be greater than or equal to 50s and less than or equal to 300s; and a wet chemical etching solution used in the wet chemical process is an alkaline wet chemical etching solution, and a volume proportion of an alkaline component (for example, NaOH or KOH) in the alkaline wet chemical etching solution may be greater than or equal to 2% and less than or equal to 20%. For example, the process temperature of the wet chemical process may be 60°C, 70°C, 75°C, 78°C, or 80°C. The process time of the wet chemical process may be 50s, 55s, 60s, 100s, 150s, 200s, or 300s. When the wet chemical etching solution used in the wet chemical process is the alkaline wet chemical etching solution, the volume proportion of the alkaline component in the alkaline wet chemical etching solution may be 2%, 3%, 6%, 9%, 12%, 15%, or 20%. In this case, both the process temperature and the process time of the wet chemical process affect a depth by which the surface of the isolation region is caused to be recessed into the silicon substrate relative to the surface of each of the second regions through the wet chemical process. Based on this, when the process temperature of the wet chemical process falls within the foregoing range, a small depth by which the surface of the isolation region is recessed into the silicon substrate relative to the surface of each of the second regions caused by a low process temperature can be prevented. In addition, a large depth by which the surface of the isolation region is recessed into the silicon substrate relative to the surface of each of the second regions caused by a high process temperature can also be prevented. For beneficial effects of preventing the depth by which the surface of the isolation region is recessed into the silicon substrate relative to the surface of each of the second regions from being excessively small and excessively large, reference may be made to the foregoing content. Besides, beneficial effects of the process time and the volume proportion of the alkaline component falling with the foregoing ranges are similar to the beneficial effects that the process temperature is greater than or equal to 60°C and less than or equal to 80°C, and details are not described herein again.

In addition, the flatness of the surface of the isolation region after this operation can be further improved by adding a polishing additive to the wet chemical etching solution, thereby further improving a passivation effect of the surface passivation layer on the isolation region. Specifically, a component of the polishing additive and a proportion of the polishing additive in the wet chemical etching solution may be determined according to an actual application scenario, which is not specifically limited herein. For example, the polishing additive may include sodium benzoate, a defoaming agent, a surfactant, and the like. A volume proportion of the polishing additive in the wet chemical etching solution may be greater than or equal to 0.5% and less than or equal to 5%.

It should be noted that, When the manufactured back contact solar cell further includes a second passivation layer between the second regions and the second doped semiconductor layer, after the surface of the isolation region and the surface of each of the second regions are caused to be recessed into the silicon substrate relative to the surface of each of the first regions and before the second doped semiconductor layer is formed on the second regions, the method for manufacturing a back contact solar cell further includes the following steps: First, a second passivation layer is formed on the second regions by using a deposition and etching process.

Alternatively, as shown in FIG. 15, after the surface of the isolation region and the surface of each of the second regions are caused to be recessed into the silicon substrate relative to the surface of each of the first regions, and before the second doped semiconductor layer is formed on the second regions, a second passivation layer 19 may be deposited on the first doped semiconductor layer, the second regions, and the isolation regions by using a chemical vapor deposition process. As shown in FIG. 18 and FIG. 19, after the second mask layer 21 is formed and selective etching is performed on the second doped semiconductor layer using the second mask layer 21, selective etching is performed on the second passivation layer 19. In this case, there is no need to additionally form a corresponding mask layer for forming the second passivation layer 19, thereby simplifying the manufacturing procedure of the back contact solar cell.

In addition, in a case that the manufactured back contact solar cell further includes a surface passivation layer covering the first doped semiconductor layer, the second doped semiconductor layer, and the isolation regions, after the surface of the isolation region is caused to be recessed into the silicon substrate relative to the surface of each of the second regions, as shown in FIG. 21, a surface passivation layer 17 covering the first doped semiconductor layer 12, the second doped semiconductor layer 13, and the isolation regions 16 may be formed by using a chemical vapor deposition process. For a material and a thickness of the surface passivation layer 17, reference may be made to the foregoing content.

For beneficial effects of the second aspect and various implementations of the second aspect in the embodiments of the present invention, reference may be made to the analysis of the beneficial effects of the first aspect and various implementations of the first aspect, and details are not described herein again.

In addition, an embodiment of the present invention further provides a comparative example and an example to describe a manufacturing procedure and operating performance of the back contact solar cell provided in the embodiments of the present invention. Table 1 shows test results of back contact solar cells corresponding to Example 1 and Comparative Example 1.

### Example 1

Step 1: Alkaline polishing was performed on a monocrystalline silicon wafer by using a 15% alkaline solution, to form a smooth and clean silicon surface.

Step 2: A tunneling oxide layer and an intrinsic polysilicon layer were deposited on the surface of the monocrystalline silicon wafer. A thickness of the tunneling oxide layer is 1.8 nm, and a thickness of the intrinsic polysilicon layer is 350 nm.

Step 3: Boron doping treatment was performed on the deposited intrinsic polysilicon layer to form the intrinsic polysilicon layer into a P-type doped polysilicon layer; and a borosilicate glass layer was formed on the P-type doped polysilicon layer. A doping concentration of boron is 8 × 10¹⁹/cm³.

Step 4: Heat treatment was performed on the borosilicate glass layer by using a laser etching process to prepare a mask layer with a specific pattern. A laser may be a picosecond laser, a processing power of the laser may be 40 W, and a diameter of a spot of the laser is 200 µm.

Step 5: Part of the P-type doped polysilicon layer was selectively removed using the mask layer; and surface etching treatment was performed on the monocrystalline silicon wafer, to form a groove structure. A main component of a used etching solution includes alkali and a polishing additive. A concentration of the alkali in the etching solution is 5%, an etching temperature is 82°C, a process time is 300s, a volume proportion of the polishing additive is 2%, and main components of the polishing additive include sodium benzoate, a defoaming agent, and a surfactant.

Step 6: A tunneling oxide layer and an N-type doped polysilicon layer that are stacked in sequence were formed at a groove bottom of the groove structure; and a part of the monocrystalline silicon wafer located between the P-type doped polysilicon layer and the N-type doped polysilicon layer was caused to be recessed into a silicon substrate relative to a bottom surface of the groove structure. A thickness of the N-type doped polysilicon layer is greater than or equal to 150 nm and less than or equal to 180 nm. A thickness of the tunneling oxide layer is greater than or equal to 0.5 nm and less than or equal to 3 nm. A depth by which the part of the monocrystalline silicon wafer located between the P-type doped polysilicon layer and the N-type doped polysilicon layer is recessed into the silicon substrate is less than 3000 nm.

Step 7: A surface passivation layer covering the monocrystalline silicon wafer, the P-type doped polysilicon layer, and the N-type doped polysilicon layer was formed.

### Comparative Example 1

In addition to Step 6, other steps of the manufacturing method corresponding to Comparative Example 1 are the same as the manufacturing procedure in Example 1. In the manufacturing method provided in Comparative Example 1, after the tunneling oxide layer and the N-type doped polysilicon layer that are stacked in sequence were formed at the groove bottom of the groove structure, the depth by which the part of the monocrystalline silicon wafer located between the P-type doped polysilicon layer and the N-type doped polysilicon layer is recessed into the silicon substrate was set to be greater than 5 µm and a surface of the part of the monocrystalline silicon wafer located between the P-type doped polysilicon layer and the N-type doped polysilicon layer was set to be a textured surface.

**Table 1 Test results of back contact solar cells corresponding to Example 1 and Comparative Example 1**

| Project | Efficiency (%) | Open-circuit voltage (mV) | Short-circuit current (A) | Fill factor (%) |
|---|---|---|---|---|
| Comparative Example 1 | 26.018 | 738.7 | 14.164 | 82.82 |
| Example 1 | 26.129 | 740.3 | 14.178 | 82.91 |

It can be seen from the data shown in Table 1 that, in the back contact solar cell formed by the manufacturing method provided in Example 1, because a depth by which the isolation region is recessed into the silicon substrate is small, movement distances of carriers can be shortened. In addition, when the back contact solar cell further includes a surface passivation layer, a passivation effect of the surface passivation layer on the isolation region can also be improved, so that the operating efficiency, an open-circuit voltage, a short-circuit current, and a fill factor of the back contact solar cell are higher than those of the back contact solar cell obtained through the manufacturing method corresponding to Comparative Example 1. That is, the back contact solar cell provided in the embodiments of the present invention has higher operating performance.

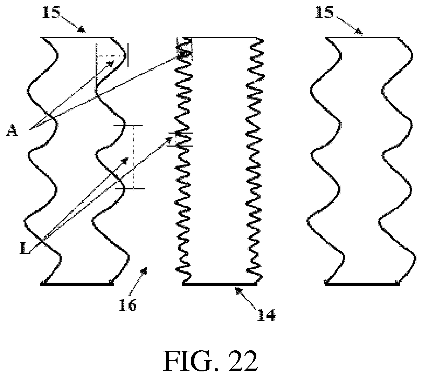

As shown in FIG. 22, in some other specific embodiments, a provided back contact solar cell includes a silicon substrate 11, and a first doped semiconductor layer 12 and a second doped semiconductor layer 13 alternately distributed at intervals on a back surface of the silicon substrate 11, where a conductivity type of the first doped semiconductor layer 12 is opposite to a conductivity type of the second doped semiconductor layer 13, the first doped semiconductor layer 12 is a P-type doped polysilicon layer, and the second doped semiconductor layer 13 is an N-type doped polysilicon layer.

In the back surface of the silicon substrate 11, regions corresponding to the first doped semiconductor layer 12 are defined as first regions 14, regions corresponding to the second doped semiconductor layer 13 are defined as second regions 15, and a region located between each first region 14 and a second region 15 adjacent to the first region is defined as an isolation region 16, where a plurality of isolation regions 16 are provided. A side surface (side wall surface) of each of the first doped semiconductor layer 12 and/or the second doped semiconductor layer 13 close to the isolation region 16 is of a wave-shaped structure. It is easily understood that a corresponding silicon substrate 11 at a side wall (side wall surface) of each of the first regions 14 and the second regions 15 close to the isolation region 16 is also of a wave-shaped structure.

A first passivation layer (tunneling passivation layer, not shown in the figure) exists between the first doped semiconductor layer 12 and the silicon substrate 11; and a second passivation layer (tunneling passivation layer, not shown in the figure) exists between the second doped semiconductor layer 13 and the silicon substrate 11.

A side wall of the P-type doped polysilicon layer is of a wave-shaped structure, and in the wave-shaped structure, an amplitude A (a distance from a peak to a valley along a direction from the P-type doped polysilicon layer to the N-type doped polysilicon layer) ranges from 3 µm to 15 µm; and a step length L (a distance between every two adjacent peaks along an extension direction of the isolation region 16) ranges from 3 µm to 15 µm.

A side wall of the N-type doped polysilicon layer is of a wave-shaped structure, and in the wave-shaped structure, along a direction from the P-type doped polysilicon layer to the N-type doped polysilicon layer, an amplitude A (a distance from a peak to a valley) ranges from 10 µm to 70 µm, and preferably, ranges from 30 µm to 60 µm; and a step length L (a distance between every two adjacent peaks along an extension direction of the isolation region 16) ranges from 10 µm to 40 µm.

In addition, in the foregoing wave-shaped structures, a fluctuation curve is not completely smooth but sawtooth-shaped, which can increase the probability of light scattering and scatter more light into the isolation region 16.

### Example 2

This example is a further improved specific example based on the implementation solution (shown by FIG. 22) above, and a difference lies in that, a fluctuation amplitude A of the second doped semiconductor layer 13 (N-type doped polysilicon layer) is different from a fluctuation amplitude of the first doped semiconductor layer 12 (P-type doped polysilicon layer). Specifically, the fluctuation amplitude of the second doped semiconductor layer 13 is greater than the fluctuation amplitude of the first doped semiconductor layer 12, and a sum of the amplitude A of the first doped semiconductor layer 12 and the amplitude A of the second doped semiconductor layer 13 is less than 50% of an average width of the isolation region 16. In this way, it is ensured that the first doped semiconductor layer 12 is effectively separated from the second doped semiconductor layer 13, thereby avoiding a risk of current leakage. The width of the isolation region 16 is 100 µm, the amplitude A of the first doped semiconductor layer 12 is 3 µm, and the amplitude A of the second doped semiconductor layer 13 is 35 µm.

Generally, to ensure that the P-type doped polysilicon layer is effectively separated from the N-type doped polysilicon layer, a specific effective width of the isolation region 16 needs to be ensured, so that the sum of the amplitude A of the first doped semiconductor layer 12 and the amplitude A of the second doped semiconductor layer 13 is less than 50% of the average width of the isolation region 16. In addition, side walls of the first doped semiconductor layer and each of the first regions 14 facing the isolation region 16 are relatively high, and side walls of the second doped semiconductor layer 13 and each of the second regions 15 facing the isolation region 16 are relatively low, there is a high risk of current leakage on a side with a relatively high side wall (the P-type doped polysilicon layer) and it is difficult to implement process control on a fluctuation form. Therefore, the amplitude A of the first doped semiconductor layer 12 is set to be relatively small while the amplitude A of the second doped semiconductor layer 13 is set to be relatively large in a targeted manner, to control the risk of current leakage and facilitate process control.

### Example 3

This example is a further improved specific example based on the implementation solution (shown by FIG. 22) above, and a difference lies in that, a fluctuation frequency of a fluctuation structure of the first doped semiconductor layer 12 is different from a fluctuation frequency of a fluctuation structure of the second doped semiconductor layer 13. Specifically, the fluctuation frequency of the second doped semiconductor layer 13 is less than the fluctuation frequency of the first doped semiconductor layer 12. The step length L (a distance between every two adjacent peaks along an extension direction of the isolation region 16) of the first doped semiconductor layer 12 is set to 5 µm, and the step length L (a distance between every two adjacent peaks along an extension direction of the isolation region 16) of the second doped semiconductor layer 13 is set to 20 µm.

It should be understood that a larger step length L of a fluctuation structure indicates a smaller fluctuation frequency corresponding to the fluctuation structure; on the contrary, a smaller step length L of a fluctuation structure indicates a larger fluctuation frequency corresponding to the fluctuation structure.

In an actual application, when a large number of peaks in the wave-shaped structures are opposite to each other, a gap between the wave-shaped structures is reduced, leading to a large number of current leakage risk points. In this example, the fluctuation frequency of the first doped semiconductor layer 12 is different from the fluctuation frequency of the second doped semiconductor layer 13, so that a case that a large number of peaks at the same frequency are opposite to each other in a direction facing the isolation region can be avoided, and the foregoing current leakage risk points can be overcame through setting of the fluctuation frequencies.

### Example 4

This example is a further improved specific example based on the implementation solution (shown by FIG. 22) above, and a difference lies in that:
In this example, in the wave-shaped structure of the side wall of the P-type doped polysilicon layer, the amplitude A (a distance from a peak to a valley along a direction from the P-type doped polysilicon layer to the N-type doped polysilicon layer) is 5 µm, and the step length L (a distance between every two adjacent peaks along an extension direction of the isolation region 16) is 8 µm; and in the wave-shaped structure of the side wall of the N-type doped polysilicon layer, the amplitude A (a distance from a peak to a valley along a direction from the P-type doped polysilicon layer to the N-type doped polysilicon layer) is 20 µm, and the step length L (a distance between every two adjacent peaks along an extension direction of the isolation region 16) is 30 µm.

By optimizing the fluctuation amplitudes and the fluctuation frequencies (shown by the step lengths L) of the first doped semiconductor layer 12 and the second doped semiconductor layer 13 in the foregoing implementation, a case that a large number of peaks are opposite to each other in a direction facing the isolation region can be avoided. In addition, the amplitude A of the first doped semiconductor layer 12 is set to be relatively small while the amplitude A of the second doped semiconductor layer 13 is set to be relatively large, thereby overcoming the current leakage risk points through collaboration and facilitating process control on a side with a relatively high side wall (the P-type doped polysilicon layer).

In the foregoing description, technical details such as composition and etching of each layer are not described in detail. However, a person skilled in the art should understand that a layer, a region, and the like of a required shape may be formed through various technical means. In addition, to form the same structure, a person skilled in the art may further design a method that is not exactly the same as the method described above. In addition, although the embodiments are separately described above, this does not mean that the measures in the embodiments cannot be advantageously used in combination.

Embodiments of the present disclosure are described above. However, the embodiments are merely for illustrative purposes and are not intended to limit the scope of the present disclosure. The scope of the present invention is defined by the appended claims. A person skilled in the art may make various substitutes and modifications without departing from the scope of the present disclosure, and the substitutes and modifications shall fall within the scope of the present disclosure.

## Claims

1. A back contact solar cell, comprising: a silicon substrate (11), and a first doped semiconductor layer (12) and a second doped semiconductor layer (13) alternately distributed at intervals on a back surface of the silicon substrate (11), wherein
a conductivity type of the first doped semiconductor layer (12) is opposite to a conductivity type of the second doped semiconductor layer (13); and in the back surface of the silicon substrate (11), regions corresponding to the first doped semiconductor layer (12) are defined as first regions (14), regions corresponding to the second doped semiconductor layer (13) are defined as second regions (15), and a region located between each first region (14) and a second region (15) adjacent to the first region (14) is defined as an isolation region (16), wherein a plurality of isolation regions (16) are provided; and
a side surface of each of the first doped semiconductor layer (12) and the second doped semiconductor layer (13) close to the isolation region (16) is wave-shaped,
**characterized in that** a fluctuation amplitude corresponding to the side surface of the second doped semiconductor layer (13) close to the isolation region (16) is greater than a fluctuation amplitude corresponding to the side surface of the first doped semiconductor layer (12) close to the isolation region (16), and/or a fluctuation frequency corresponding to the side surface of the second doped semiconductor layer (13) close to the isolation region (16) is less than a fluctuation frequency corresponding to the side surface of the first doped semiconductor layer (12) close to the isolation region (16).

2. The back contact solar cell according to claim 1, wherein a surface of each of the second regions (15) is recessed into the silicon substrate (11) relative to a surface of each of the first regions (14); and a surface of the isolation region (16) is recessed into the silicon substrate (11) relative to the surface of each of the second regions (15).

3. The back contact solar cell according to any of claims 1 or 2, wherein at least part of a surface in side walls of the isolation region (16) is arranged obliquely relative to a horizontal plane, so that a cross-sectional area of at least part of the isolation region (16) gradually increases along a direction from a light receiving surface of the silicon substrate (11) to the back surface.

4. The back contact solar cell according to any of claims 1 to 3, wherein a surface of each of the second regions (15) is recessed into the silicon substrate (11) relative to a surface of each of the first regions (14); a surface of the isolation region (16) is recessed into the silicon substrate (11) relative to the surface of each of the second regions (15), and a depth by which the surface of the isolation region (16) is recessed into the silicon substrate (11) relative to the surface of each of the first regions (14) is less than 3000 nm.

5. The back contact solar cell according to claim 4, wherein a roughness of the surface of the isolation region (16) is less than or equal to 30 µm per 10000 square micrometers; and/or
a length of the isolation region (16) along an arrangement direction of the first regions (14) and the second regions (15) is greater than or equal to 20 µm and less than or equal to 110 µm.

6. The back contact solar cell according to any of claims 4 or 5, wherein the surface of each of the second regions (15) is a planar surface; and/or
a depth by which the surface of each of the second regions (15) is recessed into the silicon substrate (11) is greater than or equal to 100 nm and less than or equal to 1000 nm; and/or
a height difference between the surface of each of the second regions (15) and the surface of the isolation region (16) is greater than or equal to 300 nm and less than 2000 nm.

7. The back contact solar cell according to any of claims 4 to 6, wherein at least part of a surface in side walls of the isolation region (16) is arranged obliquely relative to a horizontal plane, so that a cross-sectional area of at least part of the isolation region (16) gradually increases along a direction from a light receiving surface of the silicon substrate (11) to the back surface.

8. The back contact solar cell according to any of claims 4 to 7, wherein the back contact solar cell further comprises a surface passivation layer (17) covering the first doped semiconductor layer (12), the second doped semiconductor layer (13), and the isolation regions (16); and/or
the back contact solar cell further comprises a first passivation layer (18) between the first regions (14) of the silicon substrate (11) and the first doped semiconductor layer (12); and/or
the back contact solar cell further comprises a second passivation layer (19) between the second regions (15) of the silicon substrate (11) and the second doped semiconductor layer (13).

9. The back contact solar cell according to claim 8, wherein, in a case that the back contact solar cell comprises the first passivation layer (18) and the first passivation layer (18) is a tunneling passivation layer, the first doped semiconductor layer (12) is a doped polysilicon layer; and/or
in a case that the back contact solar cell comprises the second passivation layer (19) and the second passivation layer (19) is a tunneling passivation layer, the second doped semiconductor layer (13) is a doped polysilicon layer.

10. A method for manufacturing a back contact solar cell, comprising:
providing a silicon substrate (11), wherein a back surface of the silicon substrate (11) comprises first regions (14) and second regions (15) alternately distributed at intervals and an isolation region (16) located between each first region (14) and a second region (15) adjacent to the first region (14);
forming a first doped semiconductor layer (12) on the first regions (14), and causing a surface of the isolation region (16) and a surface of each of the second regions (15) to be recessed into the silicon substrate (11) relative to a surface of each of the first regions (14); and
forming a second doped semiconductor layer (13) on the second regions (15), and causing the surface of the isolation region (16) to be recessed into the silicon substrate (11) relative to the surface of each of the second regions (15), and causing a depth by which the surface of the isolation region (16) is recessed into the silicon substrate (11) relative to the surface of each of the first regions (14) to be less than 3000 nm,
wherein a side surface of each of the first doped semiconductor layer (12) and the second doped semiconductor layer (13) close to the isolation region (16) is wave-shaped,
**characterized in that** a fluctuation amplitude corresponding to the side surface of the second doped semiconductor layer (13) close to the isolation region (16) is greater than a fluctuation amplitude corresponding to the side surface of the first doped semiconductor layer (12) close to the isolation region (16), and/or a fluctuation frequency corresponding to the side surface of the second doped semiconductor layer (13) close to the isolation region (16) is less than a fluctuation frequency corresponding to the side surface of the first doped semiconductor layer (12) close to the isolation region (16).

11. The method for manufacturing a back contact solar cell according to claim 10, wherein after the providing a silicon substrate (11) and before the forming a first doped semiconductor layer (12) on the first regions (14), the method for manufacturing a back contact solar cell further comprises: forming a first passivation layer (18) on the first regions (14); and/or
after the causing a surface of the isolation region (16) and a surface of each of the second regions (15) to be recessed into the silicon substrate (11) relative to a surface of each of the first regions (14) and before the forming a second doped semiconductor layer (13) on the second regions (15), the method for manufacturing a back contact solar cell further comprises: forming a second passivation layer (19) on the second regions (15); and/or
after the causing the surface of the isolation region (16) to be recessed into the silicon substrate (11) relative to the surface of each of the second regions (15), the method for manufacturing a back contact solar cell further comprises: forming a surface passivation layer (17) covering the first doped semiconductor layer (12), the second doped semiconductor layer (13), and the isolation regions (16).

## Patentansprüche

1. Rückkontakt-Solarzelle, umfassend: ein Siliziumsubstrat (11) und eine erste dotierte Halbleiterschicht (12) und eine zweite dotierte Halbleiterschicht (13), die abwechselnd in Abständen auf einer Rückseite des Siliziumsubstrats (11) verteilt sind, wobei
der Leitfähigkeitstyp der ersten dotierten Halbleiterschicht (12) entgegengesetzt zum Leitfähigkeitstyp der zweiten dotierten Halbleiterschicht (13) ist; und in der Rückseite des Siliziumsubstrats (11) Bereiche, die der ersten dotierten Halbleiterschicht (12) entsprechen, als erste Bereiche (14) definiert sind, Bereiche, die der zweiten dotierten Halbleiterschicht (13) entsprechen, als zweite Bereiche (15) definiert sind, und ein Bereich, der sich zwischen jedem ersten Bereich (14) und einem zweiten Bereich (15), der an den ersten Bereich (14) angrenzt, befindet, als Isolationsbereich (16) definiert ist, wobei eine Vielzahl von Isolationsbereichen (16) vorgesehen ist; und
eine Seitenfläche von jedem der ersten dotierten Halbleiterschicht (12) und der zweiten dotierten Halbleiterschicht (13) in der Nähe des Isolationsbereichs (16) wellenförmig ist,
**dadurch gekennzeichnet, dass** eine Schwankungsamplitude, die der Seitenfläche der zweiten dotierten Halbleiterschicht (13) nahe dem Isolationsbereich (16) entspricht, größer ist als eine Schwankungsamplitude, die der Seitenfläche der ersten dotierten Halbleiterschicht (12) nahe dem Isolationsbereich (16) entspricht, und/oder eine Schwankungsfrequenz, die der Seitenfläche der zweiten dotierten Halbleiterschicht (13) nahe dem Isolationsbereich (16) entspricht, kleiner ist als eine Schwankungsfrequenz, die der Seitenfläche der ersten dotierten Halbleiterschicht (12) nahe dem Isolationsbereich (16) entspricht.

2. Rückkontakt-Solarzelle gemäß Anspruch 1, wobei eine Oberfläche jedes der zweiten Bereiche (15), relativ zu einer Oberfläche jedes der ersten Bereiche (14), in das Siliziumsubstrat (11) vertieft ist; und eine Oberfläche des Isolationsbereichs (16), relativ zur Oberfläche jedes der zweiten Bereiche (15), in das Siliziumsubstrat (11) vertieft ist.

3. Rückkontakt-Solarzelle gemäß einem der Ansprüche 1 oder 2, wobei mindestens ein Teil einer Oberfläche in den Seitenwänden des Isolationsbereichs (16) schräg zu einer horizontalen Ebene angeordnet ist, so dass eine Querschnittsfläche von mindestens einem Teil des Isolationsbereichs (16) entlang einer Richtung von einer Lichtempfangsfläche des Siliziumsubstrats (11) zur Rückseite graduell zunimmt.

4. Rückkontakt-Solarzelle gemäß einem der Ansprüche 1 bis 3, wobei eine Oberfläche jedes der zweiten Bereiche (15), relativ zu einer Oberfläche jedes der ersten Bereiche (14), in das Siliziumsubstrat (11) vertieft ist; eine Oberfläche des Isolationsbereichs (16), relativ zur Oberfläche jedes der zweiten Bereiche (15), in das Siliziumsubstrat (11) vertieft ist, und eine Tiefe, um die die Oberfläche des Isolationsbereichs (16), relativ zur Oberfläche jedes der ersten Bereiche (14), in das Siliziumsubstrat (11) vertieft ist, weniger als 3000 nm beträgt.

5. Rückkontakt-Solarzelle gemäß Anspruch 4, wobei die Rauheit der Oberfläche des Isolationsbereichs (16) weniger als oder gleich 30 µm pro 10000 Quadratmikrometer beträgt; und/oder
eine Länge des Isolationsbereichs (16) entlang einer Anordnungsrichtung der ersten Bereiche (14) und der zweiten Bereiche (15) größer oder gleich 20 µm und kleiner oder gleich 110 µm ist.

6. Rückkontakt-Solarzelle gemäß einem der Ansprüche 4 oder 5, wobei die Oberfläche jedes der zweiten Bereiche (15) eine ebene Fläche ist; und/oder
eine Tiefe, um die die Oberfläche jedes der zweiten Bereiche (15) in das Siliziumsubstrat (11) vertieft ist, größer oder gleich 100 nm und kleiner oder gleich 1000 nm ist; und/oder
ein Höhenunterschied zwischen der Oberfläche jedes der zweiten Bereiche (15) und der Oberfläche des Isolationsbereichs (16) mindestens 300 nm und weniger als 2000 nm beträgt.

7. Rückkontakt-Solarzelle gemäß einem der Ansprüche 4 bis 6, wobei mindestens ein Teil einer Oberfläche in den Seitenwänden des Isolationsbereichs (16) schräg zu einer horizontalen Ebene angeordnet ist, so dass eine Querschnittsfläche von mindestens einem Teil des Isolationsbereichs (16) entlang einer Richtung von einer Lichtempfangsfläche des Siliziumsubstrats (11) zur Rückseite graduell zunimmt.

8. Rückkontakt-Solarzelle gemäß einem der Ansprüche 4 bis 7, wobei die Rückkontakt-Solarzelle ferner eine Oberflächenpassivierungsschicht (17) umfasst, die die erste dotierte Halbleiterschicht (12), die zweite dotierte Halbleiterschicht (13) und die Isolationsbereiche (16) bedeckt; und/oder
die Rückkontakt-Solarzelle ferner eine erste Passivierungsschicht (18) zwischen den ersten Bereichen (14) des Siliziumsubstrats (11) und der ersten dotierten Halbleiterschicht (12) umfasst; und/oder
die Rückkontakt-Solarzelle ferner eine zweite Passivierungsschicht (19) zwischen den zweiten Bereichen (15) des Siliziumsubstrats (11) und der zweiten dotierten Halbleiterschicht (13) umfasst.

9. Rückkontakt-Solarzelle gemäß Anspruch 8, wobei in einem Fall, in dem die Rückkontakt-Solarzelle die erste Passivierungsschicht (18) umfasst und die erste Passivierungsschicht (18) eine Tunnelpassivierungsschicht ist, die erste dotierte Halbleiterschicht (12) eine dotierte Polysiliziumschicht ist; und/oder
in einem Fall, in dem die Rückkontakt-Solarzelle die zweite Passivierungsschicht (19) umfasst und die zweite Passivierungsschicht (19) eine Tunnelpassivierungsschicht ist, die zweite dotierte Halbleiterschicht (13) eine dotierte Polysiliziumschicht ist.

10. Verfahren zur Herstellung einer Rückkontakt-Solarzelle, umfassend:
Bereitstellen eines Siliziumsubstrats (11), wobei eine Rückseite des Siliziumsubstrats (11) erste Bereiche (14) und zweite Bereiche (15), die abwechselnd in Abständen verteilt sind, und einen Isolationsbereich (16), der sich zwischen jedem ersten Bereich (14) und einem zweiten Bereich (15) befindet, der an den ersten Bereich (14) angrenzt, umfasst;
Bilden einer ersten dotierten Halbleiterschicht (12) auf den ersten Bereichen (14), und Veranlassen, dass eine Oberfläche des Isolationsbereichs (16) und eine Oberfläche jedes der zweiten Bereiche (15), relativ zu einer Oberfläche jedes der ersten Bereiche (14), in das Siliziumsubstrat (11) vertieft werden; und
Bilden einer zweiten dotierten Halbleiterschicht (13) auf den zweiten Bereichen (15), und Veranlassen, dass die Oberfläche des Isolationsbereichs (16), relativ zur Oberfläche jedes der zweiten Bereiche (15), in das Siliziumsubstrat (11) vertieft wird, und Veranlassen, dass eine Tiefe, um die die Oberfläche des Isolationsbereichs (16), relativ zur Oberfläche jedes der ersten Bereiche (14), in das Siliziumsubstrat (11) vertieft ist, weniger als 3000 nm beträgt,
wobei eine Seitenfläche jeder der ersten dotierten Halbleiterschicht (12) und der zweiten dotierten Halbleiterschicht (13) in der Nähe des Isolationsbereichs (16) wellenförmig ist,
**dadurch gekennzeichnet, dass** eine Schwankungsamplitude, die der Seitenfläche der zweiten dotierten Halbleiterschicht (13) nahe dem Isolationsbereich (16) entspricht, größer ist als eine Schwankungsamplitude, die der Seitenfläche der ersten dotierten Halbleiterschicht (12) nahe dem Isolationsbereich (16) entspricht, und/oder eine Schwankungsfrequenz, die der Seitenfläche der zweiten dotierten Halbleiterschicht (13) nahe dem Isolationsbereich (16) entspricht, kleiner ist als eine Schwankungsfrequenz, die der Seitenfläche der ersten dotierten Halbleiterschicht (12) nahe dem Isolationsbereich (16) entspricht.

11. Verfahren zur Herstellung einer Rückkontakt-Solarzelle gemäß Anspruch 10, wobei das Verfahren zur Herstellung einer Rückkontakt-Solarzelle nach dem Bereitstellen eines Siliziumsubstrats (11) und vor dem Ausbilden einer ersten dotierten Halbleiterschicht (12) auf den ersten Bereichen (14) ferner umfasst: Ausbilden einer ersten Passivierungsschicht (18) auf den ersten Bereichen (14); und/oder
nach der Bewirkung einer Vertiefung einer Oberfläche des Isolationsbereichs (16) und einer Oberfläche jedes der zweiten Bereiche (15), relativ zu einer Oberfläche jedes der ersten Bereiche (14), in das Siliziumsubstrat (11) und bevor dem Bilden einer zweiten dotierten Halbleiterschicht (13) auf den zweiten Bereichen (15), das Verfahren zur Herstellung einer Rückkontakt-Solarzelle ferner umfasst: Bilden einer zweiten Passivierungsschicht (19) auf den zweiten Bereichen (15); und/oder
nach der Bewrirkung einer Vertiefung einer Oberfläche des Isolationsbereichs (16), relativ zur Oberfläche jedes der zweiten Bereiche (15), in das Siliziumsubstrat (11), das Verfahren zur Herstellung einer Rückkontakt-Solarzelle ferner umfasst: Bilden einer Oberflächenpassivierungsschicht (17), die die erste dotierte Halbleiterschicht (12), die zweite dotierte Halbleiterschicht (13) und die Isolationsbereiche (16) bedeckt.

## Revendications

1. Cellule solaire à contact arrière, comprenant : un substrat de silicium (11), et une première couche semi-conductrice dopée (12) et une seconde couche semi-conductrice dopée (13) réparties alternativement à des intervalles sur une surface arrière du substrat de silicium (11), dans laquelle
un type de conductivité de la première couche semi-conductrice dopée (12) est opposé au type de conductivité de la seconde couche semi-conductrice dopée (13) ; et dans la surface arrière du substrat de silicium (11), des régions correspondant à la première couche semi-conductrice dopée (12) sont définies comme des premières régions (14), des régions correspondant à la seconde couche semi-conductrice dopée (13) sont définies comme des secondes régions (15), et une région située entre chaque première région (14) et une seconde région (15) adjacente à la première région (14) est définie comme une région d'isolation (16), dans lequel une pluralité de régions d'isolation (16) sont fournies ; et
une surface latérale de chacune de la première couche semi-conductrice dopée (12) et de la seconde couche semi-conductrice dopée (13) à proximité de la région d'isolation (16) est en forme d'onde,
**caractérisé en ce qu'**une amplitude de fluctuation correspondant à la surface latérale de la seconde couche semi-conductrice dopée (13) à proximité de la région d'isolation (16) est supérieure à une amplitude de fluctuation correspondant à la surface latérale de la première couche semi-conductrice dopée (12) à proximité de la région d'isolation (16), et/ou une fréquence de fluctuation correspondant à la surface latérale de la seconde couche semi-conductrice dopée (13) à proximité de la région d'isolation (16) est inférieure à une fréquence de fluctuation correspondant à la surface latérale de la première couche semi-conductrice dopée (12) à proximité de la région d'isolation (16).

2. Cellule solaire à contact arrière selon la revendication 1, dans laquelle une surface de chacune des secondes régions (15) est en retrait dans le substrat de silicium (11) par rapport à une surface de chacune des premières régions (14) ; et une surface de la région d'isolation (16) est en retrait dans le substrat de silicium (11) par rapport à la surface de chacune des secondes régions (15).

3. Cellule solaire à contact arrière selon l'une quelconque des revendications 1 ou 2, dans laquelle au moins une partie d'une surface dans les parois latérales de la région d'isolation (16) est agencée de manière oblique par rapport à un plan horizontal, de sorte qu'une aire de section transversale d'au moins une partie de la région d'isolation (16) augmente progressivement le long d'une direction à partir d'une surface de réception de lumière du substrat de silicium (11) vers la surface arrière.

4. Cellule solaire à contact arrière selon l'une quelconque des revendications 1 à 3, dans laquelle une surface de chacune des secondes régions (15) est en retrait dans le substrat de silicium (11) par rapport à une surface de chacune des premières régions (14) ; une surface de la région d'isolation (16) est en retrait dans le substrat de silicium (11) par rapport à la surface de chacune des secondes régions (15), et une profondeur de retrait de la surface de la région d'isolation (16) dans le substrat de silicium (11) par rapport à la surface de chacune des premières régions (14) est inférieure à 3000 nm.

5. Cellule solaire à contact arrière selon la revendication 4, dans laquelle une rugosité de la surface de la région d'isolation (16) est inférieure ou égale à 30 µm pour 10000 micromètres carrés ; et/ou
une longueur de la région d'isolation (16) le long d'une direction d'agencement des premières régions (14) et des secondes régions (15) est supérieure ou égale à 20 µm et inférieure ou égale à 110 µm.

6. Cellule solaire à contact arrière selon l'une quelconque des revendications 4 ou 5, dans laquelle la surface de chacune des secondes régions (15) est une surface plane ; et/ou
une profondeur de retrait de la surface de chacune des secondes régions (15) dans le substrat de silicium (11) est supérieure ou égale à 100 nm et inférieure ou égale à 1000 nm ; et/ou
une différence de hauteur entre la surface de chacune des secondes régions (15) et la surface de la région d'isolation (16) est supérieure ou égale à 300 nm et inférieure à 2000 nm.

7. Cellule solaire à contact arrière selon l'une quelconque des revendications 4 à 6, dans laquelle au moins une partie d'une surface dans les parois latérales de la région d'isolation (16) est agencée de manière oblique par rapport à un plan horizontal, de sorte qu'une aire de section transversale d'au moins une partie de la région d'isolation (16) augmente progressivement le long d'une direction à partir d'une surface de réception de lumière du substrat de silicium (11) vers la surface arrière.

8. Cellule solaire à contact arrière selon l'une quelconque des revendications 4 à 7, dans laquelle la cellule solaire à contact arrière comprend en outre une couche de passivation de surface (17) recouvrant la première couche semi-conductrice dopée (12), la seconde couche semi-conductrice dopée (13) et les régions d'isolation (16) ; et/ou
la cellule solaire à contact arrière comprend en outre une première couche de passivation (18) entre les premières régions (14) du substrat de silicium (11) et la première couche semi-conductrice dopée (12) ; et/ou
la cellule solaire à contact arrière comprend en outre une seconde couche de passivation (19) entre les secondes régions (15) du substrat de silicium (11) et la seconde couche semi-conductrice dopée (13).

9. Cellule solaire à contact arrière selon la revendication 8, dans laquelle, dans un cas où la cellule solaire à contact arrière comprend la première couche de passivation (18) et la première couche de passivation (18) est une couche de passivation à effet tunnel, la première couche semi-conductrice dopée (12) est une couche de polysilicium dopée ; et/ou
dans un cas où la cellule solaire à contact arrière comprend la seconde couche de passivation (19) et la seconde couche de passivation (19) est une couche de passivation à effet tunnel, la seconde couche semi-conductrice dopée (13) est une couche de polysilicium dopée.

10. Procédé de fabrication d'une cellule solaire à contact arrière, comprenant les étapes consistant à :
fournir un substrat de silicium (11), dans lequel une surface arrière du substrat de silicium (11) comprend des premières régions (14) et des secondes régions (15) réparties alternativement à des intervalles et une région d'isolation (16) située entre chaque première région (14) et une seconde région (15) adjacente à la première région (14) ;
former une première couche semi-conductrice dopée (12) sur les premières régions (14), et amener une surface de la région d'isolation (16) et une surface de chacune des secondes régions (15) à être en retrait dans le substrat de silicium (11) par rapport à une surface de chacune des premières régions (14) ; et
former une seconde couche semi-conductrice dopée (13) sur les secondes régions (15), et amener la surface de la région d'isolation (16) à être en retrait dans le substrat de silicium (11) par rapport à la surface de chacune des secondes régions (15), et amener une profondeur de retrait de la surface de la région d'isolation (16) dans le substrat de silicium (11) par rapport à la surface de chacune des premières régions (14) à être inférieure à 3000 nm,
dans lequel une surface latérale de chacune de la première couche semi-conductrice dopée (12) et de la seconde couche semi-conductrice dopée (13) à proximité de la région d'isolation (16) est en forme d'onde,
**caractérisé en ce qu'**une amplitude de fluctuation correspondant à la surface latérale de la seconde couche semi-conductrice dopée (13) à proximité de la région d'isolation (16) est supérieure à une amplitude de fluctuation correspondant à la surface latérale de la première couche semi-conductrice dopée (12) à proximité de la région d'isolation (16), et/ou une fréquence de fluctuation correspondant à la surface latérale de la seconde couche semi-conductrice dopée (13) à proximité de la région d'isolation (16) est inférieure à une fréquence de fluctuation correspondant à la surface latérale de la première couche semi-conductrice dopée (12) à proximité de la région d'isolation (16).

11. Procédé de fabrication d'une cellule solaire à contact arrière selon la revendication 10, dans lequel, après la fourniture d'un substrat de silicium (11) et avant la formation d'une première couche semi-conductrice dopée (12) sur les premières régions (14), le procédé de fabrication d'une cellule solaire à contact arrière comprend en outre l'étape consistant à : former une première couche de passivation (18) sur les premières régions (14) ; et/ou
après avoir provoqué la mise en retrait d'une surface de la région d'isolation (16) et d'une surface de chacune des secondes régions (15) dans le substrat de silicium (11) par rapport à une surface de chacune des premières régions (14) et avant la formation d'une seconde couche semi-conductrice dopée (13) sur les secondes régions (15), le procédé de fabrication d'une cellule solaire à contact arrière comprend en outre l'étape consistant à : former une seconde couche de passivation (19) sur les secondes régions (15) ; et/ou
après avoir provoqué la mise en retrait de la surface de la région d'isolation (16) dans le substrat de silicium (11) par rapport à la surface de chacune des secondes régions (15), le procédé de fabrication d'une cellule solaire à contact arrière comprend en outre l'étape consistant à : former une couche de passivation de surface (17) recouvrant la première couche semi-conductrice dopée (12), la seconde couche semi-conductrice dopée (13) et les régions d'isolation (16).
